(19)

Europäisches Patentamt
European Patent Office
Office européen des brevets

(11) **EP 1 953 805 A1**

(12) **EUROPEAN PATENT APPLICATION**
published in accordance with Art. 158(3) EPC

(43) Date of publication:
**06.08.2008 Bulletin 2008/32**

(21) Application number: **06822564.8**

(22) Date of filing: **30.10.2006**

(51) Int Cl.:
**H01L 21/027** (2006.01)     **G02B 19/00** (2006.01)
**G03F 7/20** (2006.01)

(86) International application number:
**PCT/JP2006/321607**

(87) International publication number:
**WO 2007/055120 (18.05.2007 Gazette 2007/20)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **10.11.2005 JP 2005325787**

(71) Applicant: **NIKON CORPORATION**
**Tokyo 100-8331 (JP)**

(72) Inventor: **TANAKA, Hirohisa**
**Tokyo 1008331 (JP)**

(74) Representative: **HOFFMANN EITLE**
**Patent- und Rechtsanwälte**
**Arabellastrasse 4**
**81925 München (DE)**

(54) **LIGHTING OPTICAL SYSTEM, EXPOSURE SYSTEM, AND EXPOSURE METHOD**

(57)     An illumination optical system is arranged to adjust a polarization distribution on an illumination pupil plane or on a surface to be illuminated and thereby to illuminate the surface to be illuminated with light in a desired polarization state. The illumination optical apparatus is arranged to illuminate the surface to be illuminated (M; W) on the basis of light from a light source (1). The illumination optical apparatus includes a polarization distribution adjusting member (14) which adjusts a polarization distribution of light on the illumination pupil plane. The polarization distribution adjusting member includes an optical rotation member (9) arranged as rotatable around the optical axis (AX) of the illumination optical apparatus and adapted to provide incident light with optical rotation amounts varying according to respective positions of incidence. The optical rotation member is made of an optically active material and with thickness in the optical-axis direction varying along a predetermined direction perpendicular to the optical axis.

**Fig.1**

EP 1 953 805 A1

**Description**

**Technical Field**

The present invention relates to illumination optical apparatus, exposure apparatus, and exposure methods and, more particularly, to an illumination optical apparatus suitable for exposure apparatus for manufacturing devices such as semiconductor devices, imaging devices, liquid-crystal display devices, and thin-film magnetic heads by lithography.

**Background Art**

In a typical exposure apparatus of this type, a beam emitted from a light source travels through a fly's eye lens as an optical integrator to form a secondary light source as a substantial surface illuminant consisting of a large number of light sources. Beams from the secondary light source (a light intensity distribution formed at or near an illumination pupil) are condensed by a condenser lens to illuminate a mask with a predetermined pattern therein in a superimposed manner.

Light having passed through the pattern of the mask is guided through a projection optical system to be focused on a wafer. In this manner, the mask pattern is projected (or transferred) onto the wafer to effect exposure thereof. Since the pattern formed in the mask is a highly integrated pattern, a uniform illuminance distribution must be achieved on the wafer in order to accurately transfer this microscopic pattern onto the wafer.

For realizing an illumination condition suitable for faithfully transferring the microscopic pattern in any direction, the applicant discloses the technology of forming the secondary light source of annular shape on the rear focal plane of the fly's eye lens and making such a setting that a beam through the annular secondary light source is in a linearly polarized state in which the direction of polarization is its circumferential direction (which will be referred to hereinafter simply as "circumferential polarization state") (e.g., Patent Document 1).

Patent Document 1: WO 2005/041277

**Disclosure of the Invention**

**Problem to be Solved by the Invention**

The projection exposure of a specific pattern with light in a specific linear polarization state, without being restricted only to the above-described circumferential polarization state, is effective to improvement in resolution of the projection optical system. More generally, the projection exposure with light in a specific polarization state (which is a broad concept embracing an unpolarized state) according to the mask pattern is effective to improvement in resolution of the projection optical system.

However, in the case where the mask (or the wafer eventually) is attempted to be illuminated with light in a desired polarization state, when an optical member to change the polarization state of light is interposed in the illumination optical path, the light will not be focused in the desired polarization state and this could result in degrading the imaging performance of the projection optical system eventually. Particularly, the polarization state of light passing a peripheral region is more likely to vary than that of light passing a central region of an effective region of a lens.

The present invention has been accomplished in view of the above-described problem and an object of the invention is to provide an illumination optical apparatus capable of illuminating a surface to be illuminated with light in a desired polarization state through adjustment of a polarization distribution on the illumination pupil plane or on the surface to be illuminated. Another object of the invention is to provide an exposure apparatus and an exposure method capable of imaging a microscopic pattern in a desired polarization state on a photosensitive substrate and thereby implementing faithful and excellent exposure, using the illumination optical apparatus capable of illuminating the surface to be illuminated with light in the desired polarization state.

**Means for Solving the Problem**

In order to solve the above problem, a first aspect of the present invention provides an illumination optical apparatus which illuminates a surface to be illuminated on the basis of light from a light source, comprising:

a first polarizing member arranged as rotatable around an optical axis of the illumination optical apparatus or around an axis substantially parallel to the optical axis; and
a second polarizing member arranged as rotatable around the optical axis or around the axis substantially parallel thereto in an optical path between the first polarizing member and the surface to be illuminated,

wherein each of the first polarizing member and the second polarizing member provides incident light with variations in a polarization state different according to respective positions of incidence.

A second aspect of the present invention provides an illumination optical apparatus which illuminates a surface to be illuminated on the basis of light from a light source, comprising:

> a phase member arranged as rotatable around an optical axis of the illumination optical apparatus or around an axis substantially parallel to the optical axis, at or near a pupil plane of the illumination optical apparatus, and adapted to provide incident light with phase amounts varying according to respective positions of incidence.

A third aspect of the present invention provides an illumination optical apparatus which illuminates a surface to be illuminated on the basis of light from a light source, comprising:

> a phase member arranged as rotatable around an optical axis of the illumination optical apparatus or around an axis substantially parallel to the optical axis, near the surface to be illuminated, at a position optically conjugate with the surface to be illuminated, or near the conjugate position, and adapted to provide incident light with phase amounts varying according to respective positions of incidence.

A fourth aspect of the present invention provides an illumination optical apparatus which illuminates a surface to be illuminated on the basis of light from a light source, comprising:

> a polarization distribution adjusting member which adjusts a polarization distribution of light on an illumination pupil plane,

wherein the polarization distribution adjusting member comprises an optical rotation member arranged as rotatable around an optical axis of the illumination optical apparatus or around an axis substantially parallel to the optical axis and adapted to provide incident light with optical rotation amounts varying according to respective positions of incidence.

A fifth aspect of the present invention provides an illumination optical apparatus which illuminates a surface to be illuminated on the basis of light from a light source, comprising:

> a polarization distribution adjusting member which adjusts a polarization distribution of light on the surface to be illuminated,

wherein the polarization distribution adjusting member comprises an optical rotation member arranged as rotatable around an optical axis of the illumination optical apparatus or around an axis substantially parallel to the optical axis and adapted to provide incident light with optical rotation amounts varying according to respective positions of incidence.

A sixth aspect of the present invention provides an exposure apparatus for effecting exposure of a photosensitive substrate with a predetermined pattern, comprising:

> the illumination optical apparatus of any one of the first aspect to the fifth aspect which illuminates the predetermined pattern or the photosensitive substrate.

A seventh aspect of the present invention provides an exposure method for effecting exposure of a photosensitive substrate with a predetermined pattern, comprising:

> an illumination step for illuminating the predetermined pattern or the photosensitive substrate, using the illumination optical apparatus of any one of the first aspect to the fifth aspect.

An eighth aspect of the present invention provides a device manufacturing method comprising:

> an exposure step for effecting exposure of a photosensitive substrate with a predetermined pattern, using the exposure apparatus of the sixth aspect; and
> a development step for developing the photosensitive substrate exposed.

A ninth aspect of the present invention provides an adjustment method for an illumination optical apparatus which illuminates a surface to be illuminated on the basis of light from a light source, comprising:

> a polarization state measuring step for measuring a polarization state of light illuminating the surface to be illuminated; and

a polarizing member rotating step for rotating at least one of a first polarizing member disposed in an optical path of the illumination optical apparatus and a second polarizing member disposed in an optical path between the first polarizing member and the surface to be illuminated, around an optical axis of the illumination optical apparatus or around an axis substantially parallel to the optical axis, based on the polarization state measured.

A tenth aspect of the present invention provides a method for manufacturing an illumination optical apparatus which illuminates a surface to be illuminated on the basis of light from a light source, comprising:

a step for preparing a first polarizing member and a second polarizing member rotatable around an optical axis of the illumination optical apparatus or around an axis parallel to the optical axis; and
a step for rotationally adjusting at least one of the first polarizing member and the second polarizing member, according to the adjustment method of the ninth aspect.

**Effect of the Invention**

The illumination optical apparatus according to the typical aspect of the present invention comprises the optical rotation member arranged as rotatable around the optical axis, for example, at the position of the illumination pupil plane or at the position optically conjugate with the surface to be illuminated and adapted to provide incident light with optical rotation amounts varying according to respective positions of incidence. As a consequence, the polarization distribution of light on the illumination pupil plane or on the surface to be illuminated can be adjusted by the optical activity of this optical rotation member.

Since the illumination optical apparatus of the present invention is arranged to adjust the polarization distribution on the illumination pupil plane or on the surface to be illuminated as described above, it is able to illuminate the surface to be illuminated with light in a desired polarization state. Therefore, the exposure apparatus and exposure method of the present invention are able to image the microscopic pattern in the desired polarization state on the photosensitive substrate and thereby implement faithful and excellent exposure, using the illumination optical apparatus capable of illuminating the surface to be illuminated with light in the desired polarization state, and, in turn, to manufacture excellent devices.

**Brief Description of the Drawings**

Fig. 1 is a drawing schematically showing a configuration of an exposure apparatus according to an embodiment of the present invention.
Fig. 2 is a drawing schematically showing a configuration of a polarization distribution adjusting member according to an embodiment of the present invention
Fig. 3 is a drawing for explaining the optical activity of rock crystal.
Fig. 4 is a drawing for explaining a distribution of optical rotation amounts provided for incident light to a first optical-rotation optical member.
Fig. 5 is a drawing schematically showing a way in which the polarization distribution adjusting member of the embodiment adjusts a polarization distribution of light on the illumination pupil plane.
Fig. 6 is a drawing schematically showing a configuration of the polarization distribution adjusting member according to a first modification example.
Fig. 7 is a drawing schematically showing a way in which the polarization distribution adjusting member of the first modification example adjusts a polarization distribution of light on the illumination pupil plane.
Fig. 8 is a drawing schematically showing a configuration of the polarization distribution adjusting member according to a second modification example.
Fig. 9 is a drawing schematically showing a configuration of the polarization distribution adjusting member according to a third modification example.
Fig. 10 is a drawing schematically showing a configuration of the polarization distribution adjusting member according to a fourth modification example.
Fig. 11 is a drawing schematically showing a configuration of the polarization distribution adjusting member according to a fifth modification example.
Fig. 12 is a drawing schematically showing a configuration of the polarization distribution adjusting member according to a sixth modification example.
Fig. 13 is a drawing schematically showing configurations of the polarization distribution adjusting members according to a seventh modification example and an eighth modification example, wherein (a) is a drawing schematically showing the configuration of the polarization distribution adjusting member according to the seventh modification example and (b) a drawing schematically showing the configuration of the polarization distribution adjusting member according to the eighth modification example.

Fig. 14 is a drawing schematically showing an optical rotation amount distribution of the polarization distribution adjusting member according to a ninth modification example.

Fig. 15 is a drawing schematically showing a configuration of the polarization distribution adjusting member according to a tenth modification example.

Fig. 16 is a drawing schematically showing a configuration of the polarization distribution adjusting member according to an eleventh modification example.

Fig. 17 is a drawing schematically showing configurations of the polarization distribution adjusting members according to a twelfth modification example and a thirteenth modification example, wherein (a) is a drawing schematically showing the configuration of the polarization distribution adjusting member according to the twelfth modification example and (b) a drawing schematically showing the configuration of the polarization distribution adjusting member according to the thirteenth modification example.

Fig. 18 is a drawing schematically showing a configuration of the polarization distribution adjusting member according to a fourteenth modification example.

Fig. 19 is a drawing schematically showing a configuration of the polarization distribution adjusting member according to a fifteenth modification example.

Fig. 20 is a drawing schematically showing a configuration of the polarization distribution adjusting member according to a sixteenth modification example.

Fig. 21 is a drawing schematically showing a configuration of the polarization distribution adjusting member according to a seventeenth modification example.

Fig. 22 is a flowchart of a method for fabricating semiconductor devices as micro devices.

Fig. 23 is a flowchart of a method for fabricating a liquid-crystal display device as a micro device.

## Description of Reference Symbols

1       light source
3       polarization state switch
4       diffraction optical element
5       afocal lens
7       conical axicon system
8       zoom lens
9,      9A, 9B, 9C polarization distribution adjusting member
10      micro fly's eye lens
11      condenser optical system
12      mask blind
13      imaging optical system
14      polarization state measuring unit
15      control unit
M       mask
PL      projection optical system
W       wafer

## Best Mode for Carrying out the Invention

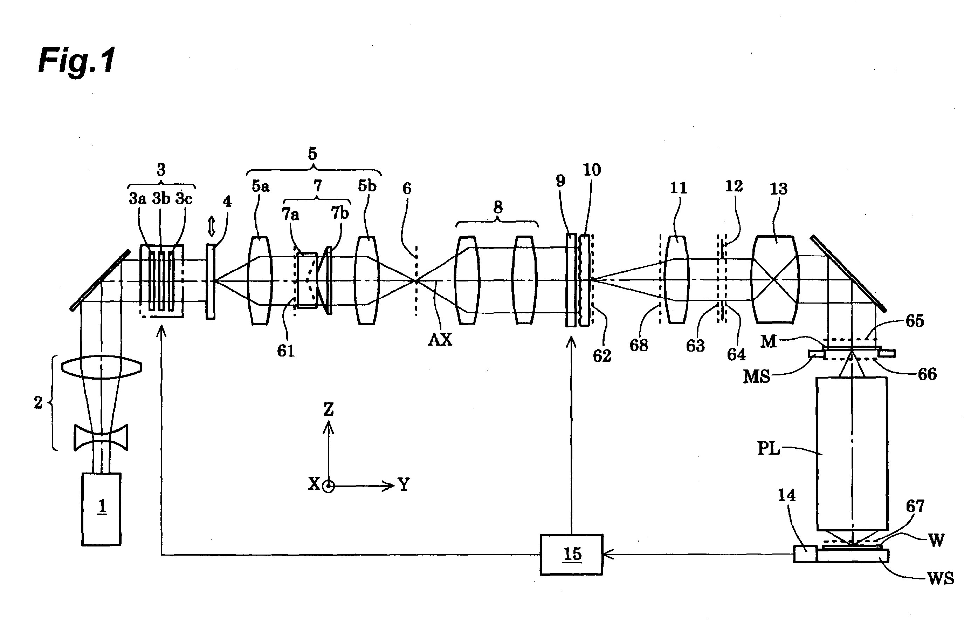

Embodiments of the present invention will be described on the basis of the accompanying drawings. Fig. 1 is a drawing schematically showing a configuration of an exposure apparatus according to an embodiment of the present invention. In Fig. 1, the Z-axis is set along a direction of a normal to a wafer W being a photosensitive substrate, the Y-axis along a direction parallel to the plane of Fig. 1 in a plane of the wafer W, and the X-axis along a direction normal to the plane of Fig. 1 in the plane of the wafer W.

With reference to Fig. 1, the exposure apparatus of the present embodiment has a light source 1 for supplying exposure light (illumination light). The light source 1 can be, for example, an ArF excimer laser light source for supplying light at the wavelength of 193 nm or a KrF excimer laser light source for supplying light at the wavelength of 248 nm. Light emitted from the light source 1 is expanded into a beam of a required sectional shape by a shaping optical system 2 and the shaped beam travels through a polarization state switch 3 and a diffraction optical element 4 for annular illumination to enter an afocal lens 5. This diffraction optical element 4 can be regarded as a beam shape changing member for changing the sectional shape of the incident beam.

The polarization state switch 3 has a quarter wave plate 3a the crystal optic axis of which is rotatable around the optical axis AX and which converts incident elliptically polarized light into linearly polarized light, a half wave plate 3b the crystal optic axis of which is rotatable around the optical axis AX and which changes the polarization direction of incident linearly polarized light, and a depolarizer (depolarizing element) 3c which can be set inserted and retracted the illumination optical path, in the order named from the light source side. The polarization state switch 3, with the depolarizer 3c being set off the illumination optical path, has a function of converting the light from the light source 1 into linearly polarized light with a desired polarization direction and letting the linearly polarized light into the diffraction optical element 4, and, with the depolarizer 3c being set in the illumination optical path, it has a function of converting the light from the light source 1 into substantially unpolarized light and letting the unpolarized light into the diffraction optical element 4.

The afocal lens 5 is an afocal system (afocal optic) so set that a front focal position of a front lens unit 5a thereof is approximately coincident with the position of the diffraction optical element 4 and that a rear focal position of a rear lens unit 5b thereof is approximately coincident with a position of a predetermined plane 6 indicated by a dashed line in the drawing. In general, a diffraction optical element is made by forming steps with a pitch approximately equal to the wavelength of the exposure light (illumination light) in a substrate and has the action to diffract an incident beam at desired angles.

Specifically, the diffraction optical element 4 for annular illumination has the following function: when a parallel beam with a rectangular cross section is incident thereto, it forms a light intensity distribution of an annular shape in its far field (or a Fraunhofer diffraction region). Therefore, a nearly parallel beam incident to the diffraction optical element 4 as a beam converting element forms a light intensity distribution of an annular shape on the pupil plane of the afocal lens 5 and then it is emitted in an annular angular distribution from the afocal lens 5. A conical axicon system 7 is disposed at or near the pupil plane of the afocal lens 5 in the optical path between the front lens unit 5a and the rear lens unit 5b of the afocal lens 5. The configuration and action of the conical axicon system 7 will be described later.

The beam having passed through the afocal lens 5 travels through a zoom lens 8 for variation in σ value (σ value = mask-side numerical aperture of the illumination optical apparatus/mask-side numerical aperture of the projection optical system) and through a polarization distribution adjusting member 9 to enter a micro fly's eye lens (or fly's eye lens) 10. The configuration and action of the polarization distribution adjusting member 9 will be described later. The micro fly's eye lens 10 is an optical element consisting of a large number of microscopic lenses with a positive refracting power arranged vertically and horizontally and densely. In general, a micro fly's eye lens is made, for example, by forming a microscopic lens group in a plane-parallel plate by etching.

Each microscopic lens forming the micro fly's eye lens is smaller than each lens element forming a fly's eye lens. In the micro fly's eye lens, different from the fly's eye lens consisting of lens elements apart from each other, the large number of microscopic lenses (fine refracting faces) are integrally formed without being apart from each other. However, from the aspect that the lens elements with the positive refracting power are arranged vertically and horizontally, the micro fly's eye lens is a wavefront-splitting type optical integrator of the same kind as the fly's eye lens.

The position of the predetermined plane 6 is located near the front focal position of the zoom lens 8 and the entrance plane of the micro fly's eye lens 10 is located near the rear focal position of the zoom lens 8. In other words, the zoom lens 8 arranges the predetermined plane 6 and the entrance plane of the micro fly's eye lens 10 substantially in the Fourier transform relation and, in turn, sets the pupil plane of the afocal lens 5 and the entrance plane of the micro fly's eye lens 10 approximately optically conjugate with each other. The polarization distribution adjusting member 9 is located immediately before the micro fly's eye lens 10 and is thus set approximately optically conjugate with the pupil plane of the afocal lens 5.

Therefore, for example, an annular illumination field is formed around the optical axis AX on the entrance plane of the micro fly's eye lens 10, as on the pupil plane of the afocal lens 5. The overall shape of this annular illumination field varies in a similarity state depending upon the focal length of the zoom lens 8. Each microscopic lens forming the micro fly's eye lens 10 has a rectangular cross section similar to a shape of an illumination field to be formed on a mask M (or a shape of an exposure region to be formed on the wafer W eventually).

The beam incident to the micro fly's eye lens 10 is two-dimensionally split by the large number of microscopic lenses to form on or near the rear focal plane thereof (or on the illumination pupil eventually), a secondary light source with a light intensity distribution approximately identical to the illumination field formed by the incident beam, i.e., a secondary light source consisting of a substantial surface illuminant of an annular shape around the optical axis AX. Beams from the secondary light source formed on or near the rear focal plane of the micro fly's eye lens 10 travel through a condenser optical system 11 to illuminate a mask blind 12 in a superimposed manner.

In this manner, a rectangular illumination field according to the shape and focal length of each microscopic lens forming the micro fly's eye lens 10 is formed on the mask blind 12 as an illumination field stop. Beams through a rectangular aperture (light transmitting portion) of the mask blind 12 are converged by an imaging optical system 13 to illuminate the mask M with a predetermined pattern therein in a superimposed manner. Namely, the imaging optical system 13 forms an image of the rectangular aperture of the mask blind 12 on the mask M.

A beam transmitted by the pattern of the mask M held on a mask stage MS travels through a projection optical system PL to form an image of the mask pattern on the wafer (photosensitive substrate) W held on a wafer stage WS. In this manner, the pattern of the mask M is sequentially transferred into each of exposure areas on the wafer W by one-shot exposure or scanning exposure while two-dimensionally driving and controlling the wafer stage WS in a plane (XY plane) perpendicular to the optical axis AX of the projection optical system PL, i.e., while two-dimensionally driving and controlling the wafer W.

Quadrupole illumination can be implemented when a diffraction optical element for quadrupole illumination (not shown) is set instead of the diffraction optical element 4 for annular illumination in the illumination optical path. The diffraction optical element for quadrupole illumination has the following function: when a parallel beam with a rectangular cross section is incident thereto, it forms a light intensity distribution of a quadrupole shape in its far field. Therefore, beams through the diffraction optical element for quadrupole illumination form, for example, a quadrupolar illumination field pattern consisting of four circular illumination fields around the optical axis AX on the entrance plane of the micro fly's eye lens 10. As a result, a secondary light source pattern of the same quadrupolar shape as the illumination field pattern formed on the entrance plane is also formed on or near the rear focal plane of the micro fly's eye lens 10.

Furthermore, ordinary circular illumination can also be implemented when a diffraction optical element for circular illumination (not shown) is set instead of the diffraction optical element 4 for annular illumination in the illumination optical path. The diffraction optical element for circular illumination has the following function: when a parallel beam with a rectangular cross section is incident thereto, it forms a light intensity distribution of a circular shape in its far field. Therefore, a beam through the diffraction optical element for circular illumination forms, for example, an illumination field of a circular shape around the optical axis AX on the entrance plane of the micro fly's eye lens 10. As a result, a secondary light source of the same circular shape as the illumination field formed on the entrance plane is also formed on or near the rear focal plane of the micro fly's eye lens 10.

Furthermore, a variety of multi-pole illuminations (dipole illumination, octupole illumination, etc.) can also be implemented when diffraction optical elements for other multi-pole illuminations (not shown) are used instead of the diffraction optical element 4 for annular illumination in the illumination optical path. Similarly, any one of modified illuminations of various forms can also be implemented when a diffraction optical element with an appropriate property (not shown) is set instead of the diffraction optical element 4 for annular illumination in the illumination optical path.

The conical axicon system 7 is composed of a first prism member 7a with a plane on the light source side and a refracting surface of a concave conical shape on the mask side, and a second prism member 7b with a plane on the mask side and a refracting surface of a convex conical shape on the light source side, in the order named from the light source side. The refracting surface of the concave conical shape of the first prism member 7a and the refracting surface of the convex conical shape of the second prism member 7b are formed in complementary shapes so as to be able to abut on each other. At least one of the first prism member 7a and the second prism member 7b is arranged as movable along the optical axis AX so as to make the space variable between the refracting surface of the concave conical shape of the first prism member 7a and the refracting surface of the convex conical shape of the second prism member 7b. The action of the conical axicon system 7 and the action of the zoom lens 8 will be described below with focus on the annular or quadrupolar secondary light source.

In a state in which the concave conical refracting surface of the first prism member 7a and the convex conical refracting surface of the second prism member 7b are in contact with each other, the conical axicon system 7 functions as a plane-parallel plate and has no effect on the annular or quadrupolar secondary light source formed. However, as the concave conical refracting surface of the first prism member 7a is separated away from the convex conical refracting surface of the second prism member 7b, the outside diameter (inside diameter) of the annular or quadrupolar secondary light source varies while the width of the annular or quadrupolar secondary light source (half of a difference between the outside diameter and the inside diameter of the annular secondary light source; half of a difference between a diameter (outside diameter) of a circle circumscribed to the quadrupolar secondary light source and a diameter (inside diameter) of a circle inscribed in the quadrupolar secondary light source) is kept constant. Namely, the separation results in varying the annular ratio (inside diameter/outside diameter) and the size (outside diameter) of the annular or quadrupolar secondary light source.

The zoom lens 8 has a function to similarly enlarge or reduce the overall shape of the annular or quadrupolar secondary light source. For example, when the focal length of the zoom lens 8 is increased from a minimum to a predetermined value, the overall shape of the annular or quadrupolar secondary light source is similarly enlarged. In other words, the action of the zoom lens 8 is to vary both the width and size (outside diameter), without change in the annular ratio of the annular or quadrupolar secondary light source. In this manner, the annular ratio and size (outside diameter) of the annular or quadrupolar secondary light source can be controlled by the actions of the conical axicon system 7 and the zoom lens 8.

The exposure apparatus of the present embodiment is provided with a polarization state measuring unit 14 for measuring a polarization state of illumination light (exposure light) incident to the wafer W, which is mounted on the wafer stage WS for holding the wafer W. The measurement result by the polarization state measuring unit 14 is supplied to a control unit 15. The detailed configuration and action of the polarization state measuring unit 14 are disclosed, for example, in Japanese Patent Application Laid-open No. 2005-5521. The polarization state measuring unit 14 is used to measure the polarization state in the pupil of the illumination light incident to the wafer W, so as to determine whether the illumination light is in an appropriate polarization state in the pupil

The control unit 15 drives the polarization state switch 3 according to need and further drives the polarization distribution adjusting member 9 as described below, based on the measurement result by the polarization state measuring unit 14, to adjust the polarization state of the illumination light on the mask M (or on the wafer W eventually) to a desired polarization state. Fig. 1 shows the configuration in which the polarization state measuring unit 14 can be mounted on the wafer stage WS, but this polarization state measuring unit 14 may be incorporated in the wafer stage WS or in another stage different form the wafer stage WS. The polarization state measuring unit 14 can be the polarization state measuring device disclosed in U.S. Pat. Published Application No. 2006/0170901. U.S. Pat. Published Application No. 2006/0170901 is incorporated herein by reference.

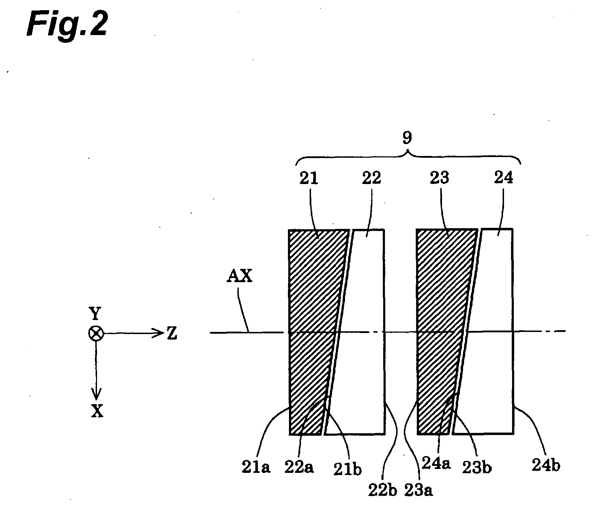

Fig. 2 is a drawing schematically showing a configuration of the polarization distribution adjusting member according to the present embodiment. The polarization distribution adjusting member 9 of the present embodiment is composed of a first optical-rotation optical member 21, a first correction optical member 22, a second optical-rotation optical member 23, and a second correction optical member 24 in the order named from the light source side. The first optical-rotation optical member 21 and the second optical-rotation optical member 23 are made of an optically active material, for example, like rock crystal, and have a wedge-shaped sectional shape in which the thickness in the optical-axis direction linearly varies along a predetermined direction perpendicular to the optical axis AX.

On the other hand, the first correction optical member 22 and the second correction optical member 24 are made of an amorphous optical material, for example, like silica glass (or a crystal optic material like fluorite) and have a wedge-shaped sectional shape as the first optical-rotation optical member 21 and the second optical-rotation optical member 23. Specifically, in a standard state shown in Fig. 2, the first optical-rotation optical member 21 has a plane (first face) 21a perpendicular to the optical axis AX, and an inclined face (second face) 21 b inclined relative to the X-direction, in the order named from the light source side. The first correction optical member 22 has an inclined face (third face) 22a complementary to the inclined face 21 b of the first optical-rotation optical member 21 and adjacent to the inclined face 21b, and a plane (fourth face) 22b perpendicular to the optical axis AX.

Similarly, in the standard state shown in Fig. 2, the second optical-rotation optical member 23 has a plane (fifth face) 23a perpendicular to the optical axis AX, and an inclined face (sixth face) 23b inclined relative to the X-direction, in the order named from the light source side. The second correction optical member 24 has an inclined face (seventh face) 24a complementary to the inclined face 23b of the second optical-rotation optical member 23 and adjacent to the inclined face 23b, and a plane (eighth face) 24b perpendicular to the optical axis AX. In this configuration, the first correction optical member 22 has a function to correct curvature of rays due to the angle deviation action of the first optical-rotation optical member 21 and the second correction optical member 24 has a function to correct curvature of rays due to the angle deviation action of the second optical-rotation optical member 23.

The first optical-rotation optical member 21 and the first correction optical member 22 are integrally held and arranged as rotatable around the optical axis AX. Similarly, the second optical-rotation optical member 23 and the second correction optical member 24 are integrally held and arranged as rotatable around the optical axis AX. The control unit 15 controls the integral rotation of the first optical-rotation optical member 21 and the first correction optical member 22 and the integral rotation of the second optical-rotation optical member 23 and the second correction optical member 24.

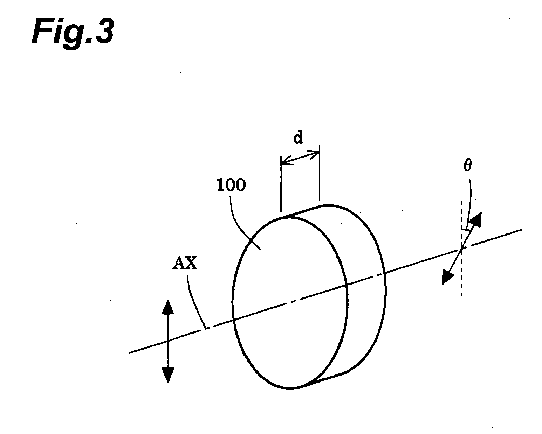

As described above, the first optical-rotation optical member 21 and the second optical-rotation optical member 23 are made of rock crystal with optical activity and the thickness thereof in the optical-axis direction linearly varies along the predetermined direction perpendicular to the optical axis AX (or along the X-direction in the standard state of Fig. 2); therefore, they have a function to provide incident light with optical rotation amounts varying according to respective positions of incidence. The optical activity of rock crystal will be briefly described with reference to Fig. 3. With reference to Fig. 3, an optical member 100 of a plane-parallel plate shape made of rock crystal in the thickness d is arranged so that its crystal optic axis agrees with the optical axis AX.

In this case, linearly polarized light incident to the optical member 100 is emitted in a state in which the direction of polarization thereof is rotated by θ around the optical axis AX, by virtue of the optical activity of the optical member 100. At this time, the rotation angle (optical rotation angle; optical rotation amount) θ of the polarization direction due to the optical activity of the optical member 100 is represented by Formula (a) below, where d is the thickness of the optical member 100 and $\rho$ the optical activity of rock crystal.

$$\theta = d \times \rho \qquad (a)$$

In general, the optical activity ρ of rock crystal has wavelength dependence (a property showing different values of optical activity depending upon wavelengths of used light: optical activity dispersion) and, specifically, it tends to increase with decrease in the wavelength of used light. According to the description on page 167 in "Oyo Kogaku II," the optical activity ρ of rock crystal for light having the wavelength of 250.3 nm is 153.9°/mm. For simplifying the description, it will be assumed hereinafter that the first optical-rotation optical member 21 and the second optical-rotation optical member 23 have the same configuration and that the first correction optical member 22 and the second correction optical member 24 have the same configuration. It will also be assumed that in the standard state shown in Fig. 2, the first optical-rotation optical member 21 and the second optical-rotation optical member 23 are positioned in the same posture.

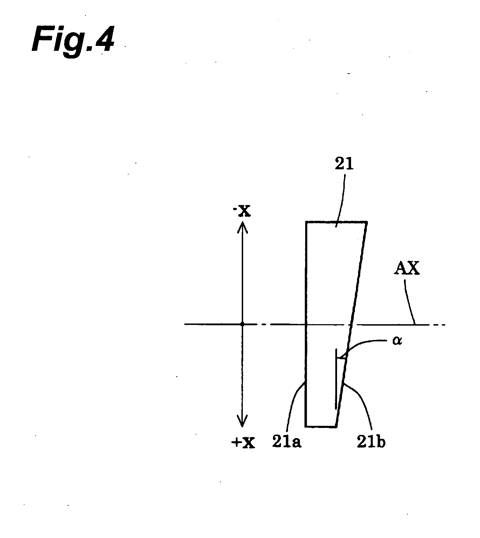

A distribution of optical rotation amounts provided for the incident light to the first optical-rotation optical member will be described with reference to Fig. 4. In Fig. 4, the first optical-rotation optical member 21 is in the standard state shown in Fig. 2 and the inclined face 21b thereof is inclined relative to the X-direction. Therefore, an optical rotation distribution S(x) of optical rotation amounts (optical rotations) provided for linearly polarized light incident to respective points along a direction of local coordinates x (having the origin on the optical axis AX and corresponding to global coordinates X) on the plane 21 a being an entrance plane of the first optical-rotation optical member 21 is represented by Eq (1) below, where α is a wedge angle of the first optical-rotation optical member 21 as an angle deviation prism and t is a thickness of rock crystal (optical material forming the first optical-rotation optical member 21) necessary for a 360-degree rotation of the polarization direction of the incident linearly polarized light.

$$S(x) = (x/t) \times \tan\alpha \qquad (1)$$

On the other hand, when the first optical-rotation optical member 21 is rotated by an angle of +β around the optical axis AX from the standard state shown in Fig. 2, the optical rotation distribution S(x) provided for linearly polarized light incident to respective points along coordinates x on the plane 21a is represented by Eq (2) below. Referring to Eqs (1) and (2), the optical rotation distribution S(x) is 0 on the optical axis AX (x = 0) and linearly varies along the x-direction in a reversely symmetric manner with respect to the optical axis AX.

$$S(x) = (x/t) \times \tan\alpha \times \cos\beta \qquad (2)$$

In the standard state shown in Fig. 2, therefore, an optical rotation distribution S(y) along the y-direction (not shown; which is a direction normal to the plane of Fig. 4 and which corresponds to the Y-direction of global coordinates) by the polarization distribution adjusting member 9 is constant and only the optical rotation distribution S(x) along the x-direction by the polarization distribution adjusting member 9 varies according to the maximum change rate. This is because the optical rotation distribution S(x) along the x-direction in Eq (1) by the first optical-rotation optical member 21 and the optical rotation distribution S(x) along the x-direction in Eq (1) by the second optical-rotation optical member 23 are combined in a summational manner with each other.

On the other hand, when the first optical-rotation optical member 21 is rotated by an angle of +β around the optical axis AX and the second optical-rotation optical member 23 is rotated by an angle of -β around the optical axis AX from the standard state shown in Fig. 2, the optical rotation distribution S(y) along the y-direction by the polarization distribution adjusting member 9 is maintained constant, and only the optical rotation distribution S(x) along the x-direction by the polarization distribution adjusting member 9 varies according to the rotation angle +β of the first optical-rotation optical member 21 (and thus according to the rotation angle -β of the second optical-rotation optical member 23).

This is because the optical rotation distribution S(y) along the y-direction by the first optical-rotation optical member 21 and the optical rotation distribution S(y) along the y-direction by the second optical-rotation optical member 23 cancel each other whereas the optical rotation distribution S(x) along the x-direction in Eq (2) by the first optical-rotation optical member 21 and the optical rotation distribution S(x) along the x-direction in Eq (2) by the second optical-rotation optical member 23 are combined in a summational manner with each other. As a result, just as in the case of the standard state shown in Fig. 2, the in-plane distribution of optical rotation amounts S(x, y) is constant along the y-direction but linearly varies along the x-direction.

In this case, as apparent with reference to Eq (2), as the magnitude |β| of the rotation angles of the first optical-rotation optical member 21 and the second optical-rotation optical member 23 increases from 0°, the change rate of the optical rotation distribution S(x) by the polarization distribution adjusting member 9 monotonically decreases. However, when the magnitude |β| of the rotation angles of the first optical-rotation optical member 21 and the second optical-rotation optical member 23 reaches 90°, the sum of the thickness in the optical-axis direction of the first optical-rotation optical member 21 and the thickness in the optical-axis direction of the second optical-rotation optical member 23 becomes constant along the x-direction, and incident light in an optional linearly polarized state passes with the polarization direction maintained, without being subjected to the optical rotation action of the polarization distribution adjusting member 9.

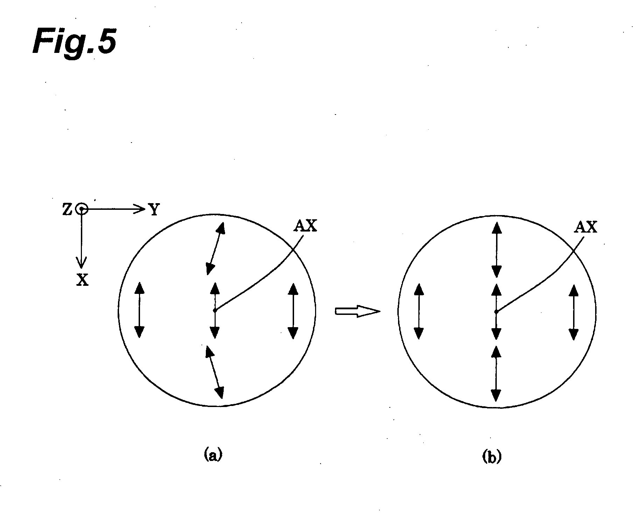

In the present embodiment, when the polarization state of light is measured with the polarization state measuring unit 14, for example, during circular illumination, the result of the measurement can be as shown in Fig. 5 (a): the polarization state is a desired X-directionally linearly polarized state in most of the region on the illumination pupil plane (the pupil plane of the projection optical system PL on the assumption that the system from the light source 1 to the projection optical system PL is regarded as an illumination optical apparatus), but the polarization distribution includes linearly polarized states reversely deviating from the desired X-directionally linearly polarized state, in regions from the center (optical axis AX) to the periphery on both sides along the X-direction. In this case, the control unit 15 drives the polarization distribution adjusting member 9, based on the measurement result by the polarization state measuring unit 14, to adjust the polarization state of the illumination light onto the wafer W to the desired polarization state.

Specifically, the control unit 15 rotates the first optical-rotation optical member 21 forming the polarization distribution adjusting member 9, by the required angle +β around the optical axis AX and rotates the second optical-rotation optical member 23 by the required angle -β around the optical axis AX, based on the measurement result by the polarization state measuring unit 14. As a result, by virtue of the action of optical activity of linear change along the X-direction of the polarization distribution adjusting member 9, the linearly polarized states in the region from the center to the periphery along the X-direction can be corrected (or adjusted) into the desired X-directionally linearly polarized state, without substantially changing the linearly polarized state in the region from the center to the periphery along the Y-direction on the illumination pupil plane, as shown in Fig. 5 (b).

In the illumination optical apparatus (1-PL; 1-13) of the present embodiment, as described above, the polarization distribution on the illumination pupil plane is adjusted by the action of optical activity of the polarization distribution adjusting member 9, whereby the wafer W can be illuminated with light in the desired polarization state. Since the exposure apparatus of the present embodiment uses the illumination optical apparatus capable of illuminating the wafer W with light in the desired polarization state, the exposure apparatus is able to focus the image of the microscopic pattern of the mask M in the desired polarization state on the wafer W and thereby to implement faithful and excellent exposure. In the above-described embodiment, the first optical-rotation optical member 21 can be regarded, for example, as a first polarizing member and the second optical-rotation optical member 23 can be regarded, for example, as a second polarizing member.

The polarization distribution adjusting member 9 in the above-described embodiment is constructed using the optical-rotation optical members (21, 23) of the wedge-shaped sectional shape in which the thickness in the optical-axis direction linearly varies along the predetermined direction perpendicular to the optical axis AX. However, without having to be limited to the wedge-shaped sectional shape, a variety of modification examples of the polarization distribution adjusting member can be contemplated, using optical-rotation optical members with other appropriate sectional shapes in which the thickness in the optical-axis direction varies along the predetermined direction perpendicular to the optical axis AX. Typical modification examples of the polarization distribution adjusting member will be described below.

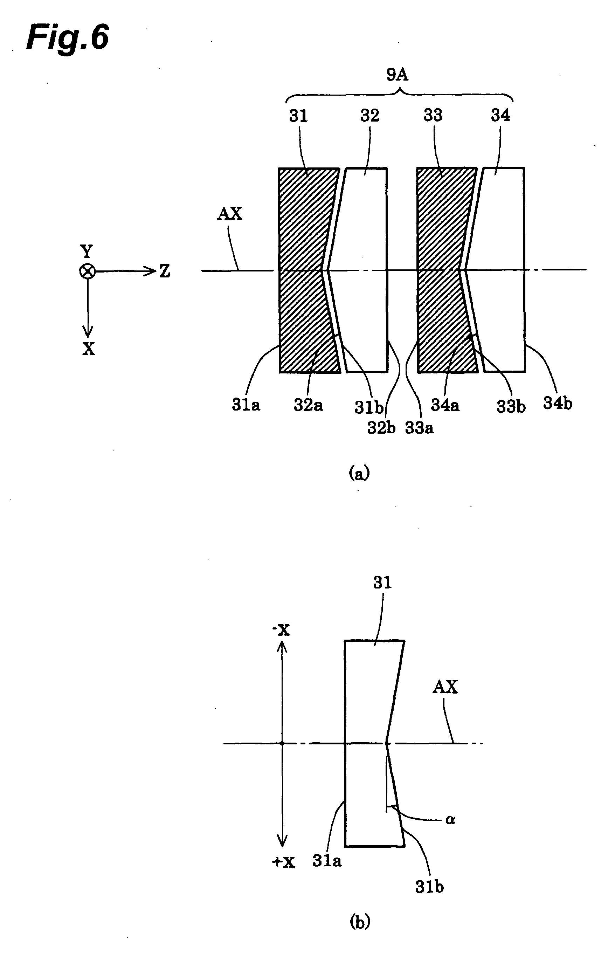

Fig. 6 is a drawing schematically showing a configuration of the polarization distribution adjusting member according to the first modification example. In the polarization distribution adjusting member 9A of the first modification example, the first optical-rotation optical member 31 is made, for example, of rock crystal and has a plane 31a on the light source side and a refracting face 31b of a concave and V shape on the mask side. In the standard state shown in Fig. 6 (a), the concave refracting face 31 b of the first optical-rotation optical member 31 is composed of two inclined faces symmetric with respect to the Y-axis passing the optical axis AX so that the thickness in the optical-axis direction of the first optical-rotation optical member 31 varies only along the X-direction. The first correction optical member 32 is made, for example, of silica glass (or fluorite or the like) and has a refracting face of a convex and V shape (a surface complementary to the concave refracting face 31b) 32a on the light source side and a plane 32b on the mask side.

Like the first optical-rotation optical member 31, the second optical-rotation optical member 33 is made, for example, of rock crystal and has a plane 33a on the light source side and a refracting face 33b of a concave and V shape on the mask side. Like the first correction optical member 32, the second correction optical member 34 is made, for example, of silica glass (or fluorite or the like) and has a refracting face of a convex and V shape (a surface complementary to the V-shaped refracting face 33b) 34a on the light source side and a plane 34b on the mask side. The first optical-rotation optical member 31 and the first correction optical member 32 are arranged as integrally rotatable around the optical axis AX, and the second optical-rotation optical member 33 and the second correction optical member 34 are arranged as integrally rotatable around the optical axis AX.

It will be assumed hereinafter for simplification of description that the first optical-rotation optical member 31 and the second optical-rotation optical member 33 have the same configuration, the first correction optical member 32 and the second correction optical member 34 have the same configuration, and the first optical-rotation optical member 31 and the second optical-rotation optical member 33 are positioned in the same posture in the standard state shown in Fig. 6 (a). With reference to Fig. 6 (b), the first optical-rotation optical member 31 is in the standard state shown in Fig. 6 (a) and the V-shaped refracting face 31b is composed of two inclined faces inclined relative to the X-direction on both sides of the optical axis AX.

Therefore, the optical rotation distribution S(x) provided for linearly polarized light incident to respective points along the x-direction on the plane 31 a being an entrance plane of the first optical-rotation optical member 31 is represented by Eq (3) below, where $\alpha$ is an inclination angle of the two inclined faces forming the V-shaped refracting face 31 b of the first optical-rotation optical member 31 and t the thickness of rock crystal necessary for a 360-degree rotation of the polarization direction of incident linearly polarized light.

$$S(x) = (|x|/t) \times \tan\alpha \qquad (3)$$

On the other hand, when the first optical-rotation optical member 31 is rotated by an angle of +$\beta$ around the optical axis AX from the standard state shown in Fig. 6 (a), the optical rotation distribution S(x) provided for linearly polarized light incident to respective points along coordinates x on the plane 31 a is represented by Eq (4) below. With reference to Eqs (3) and (4), the optical rotation distribution S(x) is 0 on the optical axis AX (x = 0) and linearly varies symmetrically along the +x-direction and -x-direction on both sides of the optical axis AX.

$$S(x) = (|x|/t) \times \tan\alpha \times \cos\beta \qquad (4)$$

Therefore, it is also the case in the first modification example that when the first optical-rotation optical member 31 is rotated by the angle +$\beta$ around the optical axis AX and the second optical-rotation optical member 33 is rotated by the angle -$\beta$ around the optical axis AX from the standard state shown in Fig. 6 (a), the optical rotation distribution S (y) along the y-direction by the polarization distribution adjusting member 9A is maintained constant, and only the optical rotation distribution S(x) along the x-direction by the polarization distribution adjusting member 9A varies according to the rotation angle +$\beta$ of the first optical-rotation optical member 31 (and thus according to the rotation angle -$\beta$ of the second optical-rotation optical member 33).

In this case, as apparent with reference to Eq (4), as the magnitude |$\beta$| of the rotation angles of the first optical-rotation optical member 31 and the second optical-rotation optical member 33 increases from 0°, the change rate of the optical rotation distribution S(x) by the polarization distribution adjusting member 9A monotonically decreases. However, when the magnitude |$\beta$| of the rotation angles of the first optical-rotation optical member 31 and the second optical-rotation optical member 33 reaches 90°, the sum of the thickness in the optical-axis direction of the first optical-rotation optical member 31 and the thickness in the optical-axis direction of the second optical-rotation optical member 33 becomes constant along the x-direction and incident light in an optional linearly polarized state passes with the polarization direction maintained, without being subjected to the action of optical activity of the polarization distribution adjusting member 9A.

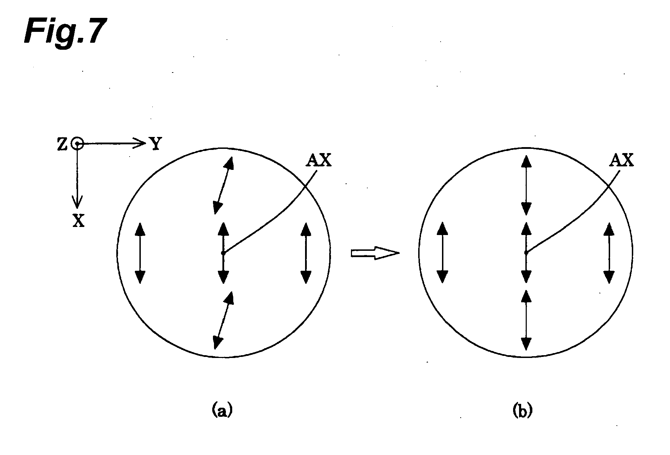

In the first modification example, when the polarization state of light is measured with the polarization state measuring unit 14, for example, during circular illumination, the measurement result can be as shown in Fig. 7 (a): the polarization state in most of the region on the illumination pupil plane is the desired X-directionally linearly polarized state, but the polarization states in the region from the center (optical axis AX) to the periphery on both sides along the X-direction are linearly polarized states deviating in the same orientation from the desired X-directionally linearly polarized state. In this case, the control unit 15 drives the polarization distribution adjusting member 9A, based on the measurement result by the polarization state measuring unit 14, to adjust the polarization state of the illumination light onto the wafer W into the desired polarization state.

Specifically, the control unit 15 rotates the first optical-rotation optical member 31 forming the polarization distribution adjusting member 9A, by the required angle +$\beta$ around the optical axis AX and rotates the second optical-rotation optical member 33 by the required angle -$\beta$ around the optical axis AX, based on the measurement result by the polarization state measuring unit 14. As a result, by virtue of the action of optical activity of linear change along the X-direction of the polarization distribution adjusting member 9A, the linearly polarized states in the region from the center to the periphery along the X-direction can be corrected (or adjusted) into the desired X-directionally linearly polarized state, without substantially changing the linearly polarized state in the region from the center to the periphery along the Y-direction on the illumination pupil plane, as shown in Fig. 7 (b). In the above-described first modification example, the first optical-rotation optical member 31 can be regarded, for example, as a first polarizing member and the second optical-rotation optical member 33 can be regarded, for example, as a second polarizing member.

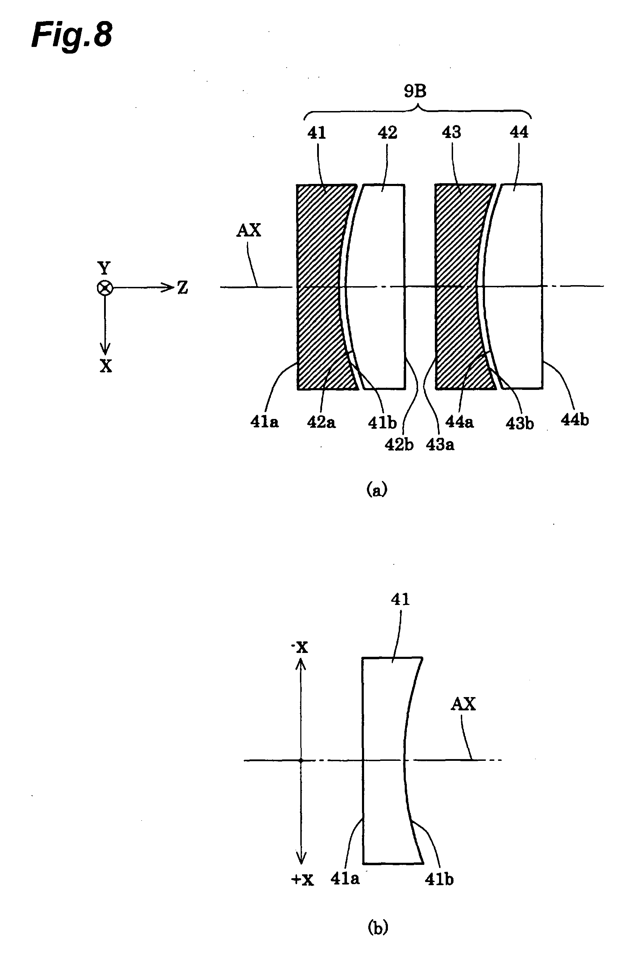

Fig. 8 is a drawing schematically showing a configuration of the polarization distribution adjusting member according to the second modification example. In the polarization distribution adjusting member 9B of the second modification example, the first optical-rotation optical member 41 is made, for example, of rock crystal and has a plane 41a on the light source side and a refracting face 41b of a concave and cylindrical shape on the mask side. In the standard state shown in Fig. 8 (a), the concave refracting face 41b of the first optical-rotation optical member 41 is formed as a cylindrical surface (precisely, a paraboloidal surface) symmetric with respect to the Y-axis passing the optical axis AX so that the thickness in the optical-axis direction of the first optical-rotation optical member 41 varies only along the X-direction. The first correction optical member 42 is made, for example, of silica glass (or fluorite or the like) and has a refracting face of a convex and cylindrical shape (a surface complementary to the concave refracting face 41b) 42a on the light source side and a plane 42b on the mask side.

Just like the first optical-rotation optical member 41, the second optical-rotation optical member 43 is made, for example, of rock crystal and has a plane 43a on the light source side and a refracting face 43b of a concave and cylindrical shape on the mask side. Just like the first correction optical member 42, the second correction optical member 44 is made, for example, of silica glass (or fluorite or the like) and has a refracting face of a convex and cylindrical shape (a surface complementary to the concave refracting face 43b) 44a on the light source side and a plane 44b on the mask side. The first optical-rotation optical member 41 and the first correction optical member 42 are arranged as integrally rotatable around the optical axis AX and the second optical-rotation optical member 43 and the second correction optical member 44 are arranged as integrally rotatable around the optical axis AX.

It will be assumed hereinafter for simplification of description that the first optical-rotation optical member 41 and the second optical-rotation optical member 43 have the same configuration, that the first correction optical member 42 and the second correction optical member 44 have the same configuration, and that the first optical-rotation optical member 41 and the second optical-rotation optical member 43 are positioned in the same posture in the standard state shown in Fig. 8 (a). With reference to Fig. 8 (b), the first optical-rotation optical member 41 is in the standard state shown in Fig. 8 (a) and the concave refracting face 41b is formed of a cylindrical face symmetric with respect to the Y-axis passing the optical axis AX.

Therefore, the optical rotation distribution S(x) provided for linearly polarized light incident to respective points along the x-direction on the plane 41a being an entrance plane of the first optical-rotation optical member 41 is represented by Eq (5) below, where a is a coefficient to define the cylindrical shape of the concave refracting face 41 b of the first optical-rotation optical member 41 and t the thickness of rock crystal necessary for a 360-degree rotation of the polarization direction of the incident linearly polarized light.

$$S(x) = ax^2/t \qquad (5)$$

On the other hand, when the first optical-rotation optical member 41 is rotated by an angle of $+\beta$ around the optical axis AX from the standard state shown in Fig. 8 (a), the optical rotation distribution S(x) provided for linearly polarized light incident to respective points along coordinates x on the plane 41 a is represented by Eq (6) below. With reference to Eqs (5) and (6), the optical rotation distribution S(x) is 0 on the optical axis AX (x = 0) and quadratically varies along the +x-direction and the -x-direction symmetrically on both sides of the optical axis AX.

$$S(x) = (ax^2/t) \times \cos\beta \qquad (6)$$

It is therefore also the case in the second modification example that when the first optical-rotation optical member 41 is rotated by the angle $+\beta$ around the optical axis AX and the second optical-rotation optical member 43 is rotated by the angle $-\beta$ around the optical axis AX from the standard state shown in Fig. 8 (a), the optical rotation distribution S(y) along the y-direction by the polarization distribution adjusting member 9B is maintained constant, and only the optical rotation distribution S(x) along the x-direction by the polarization distribution adjusting member 9B varies according to the rotation angle $+\beta$ of the first optical-rotation optical member 41 (and thus according to the rotation angle $-\beta$ of the second optical-rotation optical member 43).

In this case, as apparent with reference to Eq (6), as the magnitude $|\beta|$ of the rotation angles of the first optical-rotation optical member 41 and the second optical-rotation optical member 43 increases from 0°, the change rate of the optical rotation distribution S(x) by the polarization distribution adjusting member 9B monotonically decreases. However, when the magnitude $|\beta|$ of the rotation angles of the first optical-rotation optical member 41 and the second optical-rotation optical member 43 reaches 90°, the sum of the thickness in the optical-axis direction of the first optical-rotation optical member 41 and the thickness in the optical-axis direction of the second optical-rotation optical member 43 becomes constant along the x-direction and incident light in an optional linearly polarized state passes with the polarization direction maintained, without being subjected to the action of optical activity of the polarization distribution adjusting member 9B.

In the second modification example, as described above, the control unit 15 also rotates the first optical-rotation optical member 41 forming the polarization distribution adjusting member 9B, by the required angle $-\beta$ around the optical axis AX and rotates the second optical-rotation optical member 43 by the required angle $-\beta$ around the optical axis AX, based on the measurement result by the polarization state measuring unit 14. As a result, by virtue of the action of optical activity of quadratic change along the X-direction of the polarization distribution adjusting member 9B, the linearly polarized state in the region from the center to the periphery along the X-direction can be corrected (or adjusted) into the desired X-directionally linearly polarized state, without substantially changing the linearly polarized state in the region from the center to the periphery along the Y-direction on the illumination pupil plane. In the above-described second modification example, the first optical-rotation optical member 41 can be regarded, for example, as a first polarizing member and the second optical-rotation optical member 43 can be regarded, for example, as a second polarizing member.

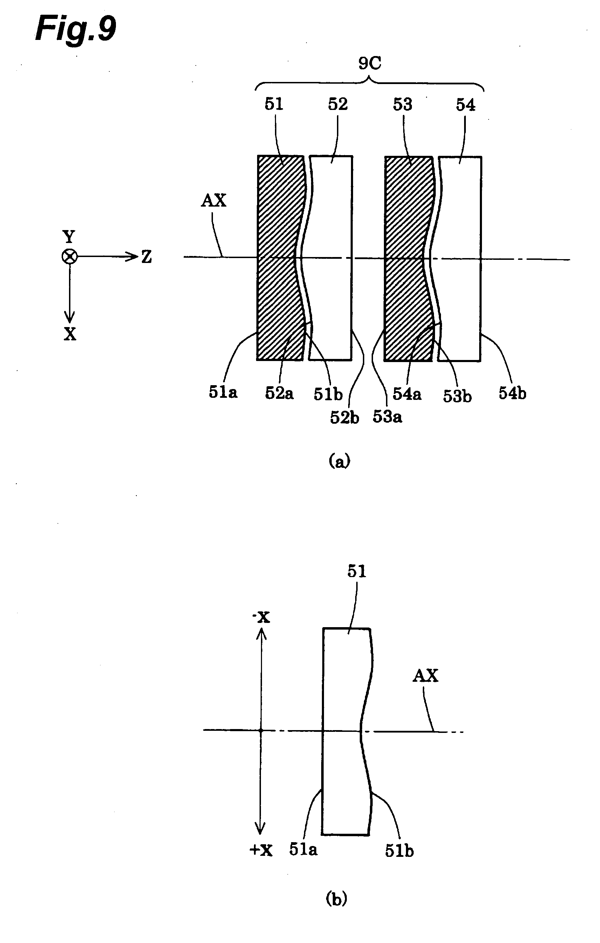

Fig. 9 is a drawing schematically showing a configuration of the polarization distribution adjusting member according to the third modification example. In the polarization distribution adjusting member 9C of the third modification example, the first optical-rotation optical member 51 is made, for example, of rock crystal and has a plane 51a on the light source side and a refracting face 51b of a higher-order non-cylindrical shape on the mask side. In the standard state shown in Fig. 9 (a), the refracting face 51b of the first optical-rotation optical member 51 is formed as a higher-order non-cylindrical surface in which the thickness in the optical-axis direction of the first optical-rotation optical member 51 varies only along the X-direction. The first correction optical member 52 is made, for example, of silica glass (or fluorite or the like) and has a refracting face of a higher-order non-cylindrical shape (a surface complementary to the refracting face 51 b) 52a on the light source side and a plane 52b on the mask side.

Just like the first optical-rotation optical member 51, the second optical-rotation optical member 53 is made, for example, of rock crystal and has a plane 53a on the light source side and a refracting face 53b of a higher-order non-cylindrical shape on the mask side. Just like the first correction optical member 52, the second correction optical member 54 is made, for example, of silica glass (or fluorite or the like) and has a refracting face of a higher-order non-cylindrical shape (a surface complementary to the refracting face 53b) 54a on the light source side and a plane 54b on the mask side. The first optical-rotation optical member 51 and the first correction optical member 52 are arranged as integrally rotatable around the optical axis AX and the second optical-rotation optical member 53 and the second correction optical member 54 are arranged as integrally rotatable around the optical axis AX.

It will be assumed hereinafter for simplification of description that the first optical-rotation optical member 51 and the second optical-rotation optical member 53 have the same configuration, that the first correction optical member 52 and the second correction optical member 54 have the same configuration; and that the first optical-rotation optical member 51 and the second optical-rotation optical member 53 are positioned in the same posture in the standard state shown in Fig. 9 (a). With reference to Fig. 9 (b), the first optical-rotation optical member 51 is in the standard state shown in Fig. 9 (a) and the refracting face 51b is formed of a higher-order non-cylindrical surface as a first-order surface along the X-direction.

Therefore, the optical rotation distribution S(x) provided for linearly polarized light incident to respective points along the x-direction on the plane 51a being an entrance plane of the first optical-rotation optical member 51 is represented by Eq (7) below, where $a_0$-$a_n$ are coefficients to define the higher-order non-cylindrical shape of the refracting face 51b of the first optical-rotation optical member 51 and t the thickness of rock crystal necessary for a 360-degree rotation of the polarization direction of the incident linearly polarized light.

$$S(x) = (a_n x^n + a_{n-1} x^{n-1} + ... + a_1 x + a_0)/t \qquad (7)$$

On the other hand, when the first optical-rotation optical member 51 is rotated by an angle of $+\beta$ around the optical axis AX from the standard state shown in Fig. 9 (a), the optical rotation distribution S(x) provided for linearly polarized light incident to respective points along coordinates x on the plane 51a is represented by Eq (8) below. With reference to Eqs (7) and (8), the optical rotation distribution S(x) is 0 on the optical axis AX (x = 0) and undergoes higher-order change along the x-direction.

$$S(x) = \{(a_n x^n + a_{n-1} x^{n-1} + ... + a_1 x + a_0)/t\} \times \cos\beta \qquad (8)$$

It is therefore also the case in the third modification example that when the first optical-rotation optical member 51 is rotated by the angle $+\beta$ around the optical axis AX and the second optical-rotation optical member 53 is rotated by the angle $-\beta$ around the optical axis AX from the standard state shown in Fig. 9 (a), the optical rotation distribution S(y) along the y-direction by the polarization distribution adjusting member 9C is maintained constant, and only the optical rotation distribution S(x) along the x-direction by the polarization distribution adjusting member 9C varies according to the rotation angle +β of the first optical-rotation optical member 51 (and thus according to the rotation angle -β of the second optical-rotation optical member 43).

In this case, as apparent with reference to Eq (8), as the magnitude |β| of the rotation angles of the first optical-rotation optical member 51 and the second optical-rotation optical member 53 increases from 0°, the change rate of the optical rotation distribution S(x) by the polarization distribution adjusting member 9C monotonically decreases. However, when the magnitude |β| of the rotation angles of the first optical-rotation optical member 51 and the second optical-rotation optical member 53 reaches 90°, the sum of the thickness in the optical-axis direction of the first optical-rotation optical member 51 and the thickness in the optical-axis direction of the second optical-rotation optical member 53 becomes constant along the x-direction and incident light in an optional linearly polarized state passes with the polarization direction maintained, without being subjected to the action of optical activity of the polarization distribution adjusting member 9C.

In the third modification example, as described above, the control unit 15 also rotates the first optical-rotation optical member 51 forming the polarization distribution adjusting member 9C by the required angle +β around the optical axis AX and rotates the second optical-rotation optical member 53 by the required angle -β around the optical axis AX, based on the measurement result by the polarization state measuring unit 14. As a result, by virtue of the action of optical activity of higher-order change along the X-direction of the polarization distribution adjusting member 9C, the linearly polarized state in the region from the center to the periphery along the X-direction can be corrected (or adjusted) into the desired X-directionally linearly polarized state, without substantially changing the linearly polarized state in the region from the center to the periphery along the Y-direction on the illumination pupil plane. In the above-described third modification example, the first optical-rotation optical member 51 can be regarded, for example, as a first polarizing member and the second optical-rotation optical member 53 can be regarded, for example, as a second polarizing member.

In the above description the polarization distribution adjusting member is provided with the two sets of optical-rotation optical members and correction optical members, but it is also possible to two-dimensionally adjust the polarization distribution on the illumination pupil plane, using the polarization distribution adjusting member provided with only one set of an optical-rotation optical member and a correction optical member. In the above description the first set of optical-rotation optical member and correction optical member and the second set of optical-rotation optical member and correction optical member have the same configuration, but it is also possible to adopt different configurations for the first set and the second set.

In the above description the first set of optical-rotation optical member and correction optical member and the second set of optical-rotation optical member and correction optical member are rotated by the same angle in opposite directions, but it is also possible to two-dimensionally adjust the polarization distribution on the illumination pupil plane, by rotating the first set and the second set independently of each other. When the spacing between the optical-rotation optical member and the correction optical member is relatively large, this spacing can cause a change in in-plane ray distribution density to easily give rise to light-quantity unevenness (illuminance unevenness); therefore, the spacing between the optical-rotation optical member and the correction optical member is preferably set as small as possible.

In the above description the face shapes of the optical-rotation optical members are set so as to achieve the optical rotation distribution without change in the polarization state of light of axial rays, and this is because the polarization state is more likely to deviate from the desired state in the peripheral region than in the central region (axial region) on the illumination pupil plane. However, without having to be limited to this, it is also possible to contemplate a variety of modification examples as to the face shapes of the optical-rotation optical members (and thus as to the optical rotation distribution).

In the above description the correction optical members are used to correct curvature of rays due to the angle deviation action of the optical-rotation optical members, but it is also possible to omit the disposition of the correction optical members in the polarization distribution adjusting member. In the above description the optical-rotation optical members are made of rock crystal, but, without being limited to rock crystal, the optical-rotation optical members can also be made of another appropriate optical material with optical activity. It is also possible to subject incident light to the action of optical activity by form birefringence.

In the above-described first modification example, it is sometimes difficult to highly accurately process the ridge-line portions (top portions or bottom portions) of the V-shaped refracting faces of the optical-rotation optical members and the correction optical members. In this case, light-quantity unevenness is likely to occur because of processing error in the ridge-line portions and it is thus preferable to reduce influence of the processing error, for example, by defocusing the ridge-line portions somewhat from the plane optically conjugate with the illumination pupil plane.

In the foregoing third modification example, the refracting faces of the higher-order non-cylindrical shapes of the optical-rotation optical members and correction optical members are desirably defined by differentiable continuous functions. When this configuration is not satisfied, for example, discontinuous light-quantity unevenness becomes likely to occur because of influence of processing error made according to a tolerance during processing of parts.

In the above description the optical-rotation optical members are rotated around the optical axis, but it is also possible to adjust the polarization distribution on the illumination pupil plane, by moving the optical-rotation optical members in a direction perpendicular to the optical axis (generally, in a direction intersecting with the optical axis). In this case, the offset component (0-order component) in the polarization distribution can be adjusted throughout the entire illumination pupil plane including the axial region, in the aforementioned embodiment and first modification example; the inclination component (first-order component) in the polarization distribution can be adjusted in the second modification example; the (n-1)th-order component in the polarization distribution can be adjusted in the third modification example. The polarization distribution can also be adjusted according to a diversity of forms by rotating the optical-rotation optical members around an axis parallel to the optical axis in a state in which the optical-rotation optical members are moved in the direction perpendicular to the optical axis.

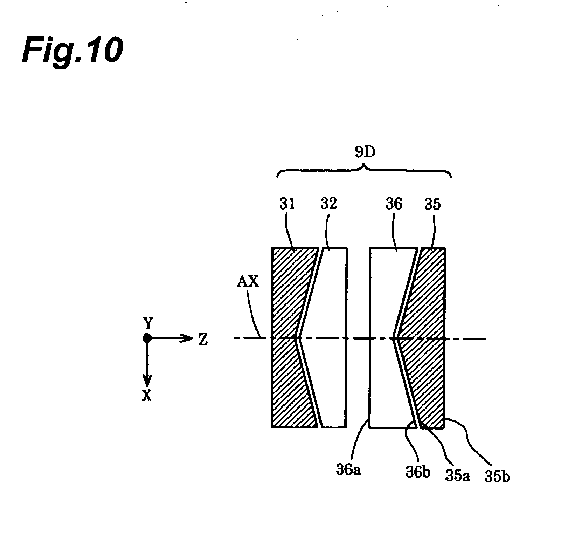

Fig. 10 is a drawing schematically showing a configuration of the polarization distribution adjusting member according to the fourth modification example. Since the polarization distribution adjusting member 9D of the fourth modification example shown in Fig. 10 has the configuration similar to that of the polarization distribution adjusting member 9A of the first modification example shown in Fig. 6, the members with the same functionality as the members shown in Fig. 6 are denoted by the same reference symbols in Fig. 10. In the fourth modification example of Fig. 10, the components different from those in the first modification example shown in Fig. 6 are the second optical-rotation optical member 35 and the second correction optical member 36.

In the polarization distribution adjusting member 9D shown in Fig. 10, the second optical-rotation optical member 35 is made, for example, of rock crystal and has a refracting face 35a of a convex and V shape on the light source side and a plane 35b on the mask side. In the standard state shown in Fig. 10, the convex refracting face 35a of the second optical-rotation optical member 35 is composed of two inclined faces symmetric with respect to the Y-axis passing the optical axis AX so that the thickness in the optical-axis direction of the second optical-rotation optical member 35 varies only along the X-direction. The second correction optical member 36 is made, for example, of silica glass (or fluorite or the like) and has a plane 36a on the light source side and a refracting face of a concave and V shape (a surface complementary to the convex refracting face 35a) 36b on the mask side.

The second optical-rotation optical member 35 and the second correction optical member 36 are arranged as integrally rotatable around the optical axis AX. When the polarization distribution adjusting member 9D of the fourth modification example is in the standard state shown in Fig. 10, it is so set that the sum of the thickness in the optical-axis direction of the first optical-rotation optical member 31 and the thickness in the optical-axis direction of the second optical-rotation optical member 35 becomes constant along the x-direction and the y-direction and that the sum of thicknesses becomes a rotation angle of the polarization direction $\theta = 180 \times n$ (n is an integer); therefore, incident light in an optional linearly polarized state passes with the polarization direction maintained, without being subjected to the action of optical activity of the polarization distribution adjusting member 9D.

The polarization state of illumination light onto the wafer W can be adjusted into a desired polarization state, by similarly changing the relative rotation angles of the first optical-rotation optical member 31 and the second optical-rotation optical member 35 as in the aforementioned embodiment and modification examples. In the above-described fourth modification example, the first optical-rotation optical member 31 can be regarded, for example, as a first polarizing member and the second optical-rotation optical member 35 can be regarded, for example, as a second polarizing member.

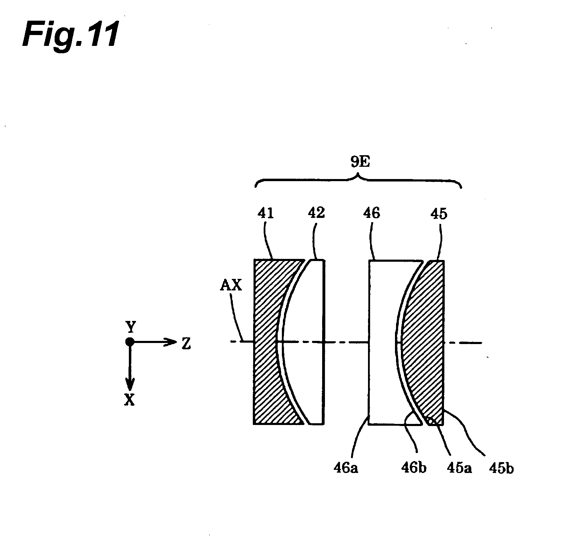

Fig. 11 is a drawing schematically showing a configuration of the polarization distribution adjusting member according to the fifth modification example. Since the polarization distribution adjusting member 9E of the fifth modification example shown in Fig. 11 has the configuration similar to that of the polarization distribution adjusting member 9B of the second modification example shown in Fig. 8, the members with the same functionality as those shown in Fig. 8 are denoted by the same reference symbols in Fig. 11. In the fifth modification example of Fig. 11, the components different from those in the second modification example shown in Fig. 8 are the second optical-rotation optical member 45 and the second correction optical member 46.

In the polarization distribution adjusting member 9E shown in Fig. 11, the second optical-rotation optical member 45 is made, for example, of rock crystal and has a refracting face 45a of a convex and cylindrical shape on the light source side and a plane 45b on the mask side. In the standard state shown in Fig. 11, the convex refracting face 45a of the second optical-rotation optical member 45 is formed as a cylindrical surface (precisely, a paraboloidal surface) symmetric with respect to the Y-axis passing the optical axis AX so that the thickness in the optical-axis direction of the second optical-rotation optical member 45 varies only along the X-direction. The second correction optical member 46 is made, for example, of silica glass (or fluorite or the like) and has a plane 46a on the light source side and a refracting face of a concave and cylindrical shape (a surface complementary to the convex refracting face 45a) 46b on the mask side.

The second optical-rotation optical member 45 and the second correction optical member 46 are arranged as integrally rotatable around the optical axis AX. When the polarization distribution adjusting member 9E of the fifth modification example is in the standard state shown in Fig. 11, it is so set that the sum of the thickness in the optical-axis direction of the first optical-rotation optical member 41 and the thickness in the optical-axis direction of the second optical-rotation optical member 45 becomes constant along the x-direction and the y-direction and that the sum of thicknesses becomes a rotation angle of the polarization direction θ = 180 × n (n is an integer); therefore, incident light in an optional linearly polarized state passes with the polarization direction maintained, without being subjected to the action of optical activity of the polarization distribution adjusting member 9E.

The polarization state of illumination light onto the wafer W can be adjusted into a desired polarization state by similarly changing the relative rotation angles of the first optical-rotation optical member 41 and the second optical-rotation optical member 45 as in the aforementioned embodiment and modification examples. In the above-described fifth modification example, the first optical-rotation optical member 41 can be regarded, for example, as a first polarizing member and the second optical-rotation optical member 45 can be regarded, for example, as a second polarizing member.

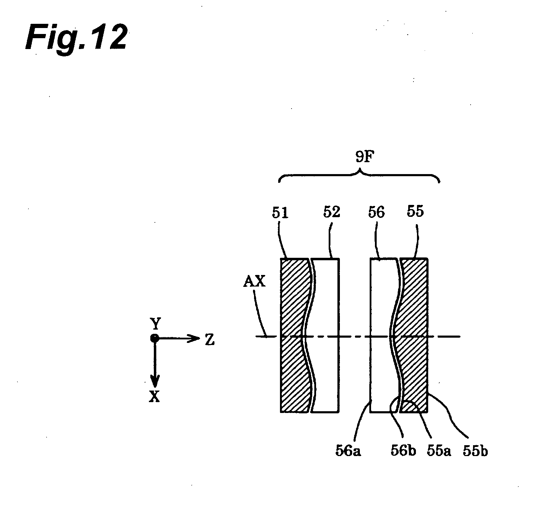

Fig. 12 is a drawing schematically showing a configuration of the polarization distribution adjusting member according to the sixth modification example. Since the polarization distribution adjusting member 9F of the sixth modification example shown in Fig. 12 has the configuration similar to that of the polarization distribution adjusting member 9C of the third modification example shown in Fig. 9, the components with the same functionality as those shown in Fig. 9 are denoted by the same reference symbols in Fig. 12. In the sixth modification example of Fig. 12, the components different from those in the third modification example shown in Fig. 9 are the second optical-rotation optical member 55 and the second correction optical member 56.

In the polarization distribution adjusting member 9F shown in Fig. 12, the second optical-rotation optical member 55 is made, for example, of rock crystal and has a refracting face 55a of a higher-order non-cylindrical shape on the light source side and a plane 55b on the mask side. In the standard state shown in Fig. 12, the refracting face 55a of the second optical-rotation optical member 55 is formed as a higher-order non-cylindrical surface in which the thickness in the optical-axis direction of the first optical-rotation optical member 55 varies only along the X-direction. The second correction optical member 56 is made, for example, of silica glass (or fluorite or the like) and has a plane 56a on the light source side and a refracting face of a higher-order non-cylindrical shape (a surface complementary to the refracting face 55a) 56b on the mask side.

The second optical-rotation optical member 55 and the second correction optical member 56 are arranged as integrally rotatable around the optical axis AX. When the polarization distribution adjusting member 9F of the fifth modification example is in the standard state shown in Fig. 12, it is so set that the sum of the thickness in the optical-axis direction of the first optical-rotation optical member 51 and the thickness in the optical-axis direction of the second optical-rotation optical member 55 is constant along the x-direction and the y-direction and that the sum of thicknesses becomes a rotation angle of the polarization direction θ = 180 × n (n is an integer); therefore, incident light in an optional linearly polarized state passes with the polarization direction maintained, without being subjected to the action of optical activity of the polarization distribution adjusting member 9F.

The polarization state of illumination light onto the wafer W can be adjusted into a desired polarization state, by similarly changing the relative rotation angles of the first optical-rotation optical member 51 and the second optical-rotation optical member 55 as in the aforementioned embodiment and modification examples. In the above-described sixth modification example, the first optical-rotation optical member 51 can be regarded, for example, as a first polarizing member and the second optical-rotation optical member 55 can be regarded, for example, as a second polarizing member.

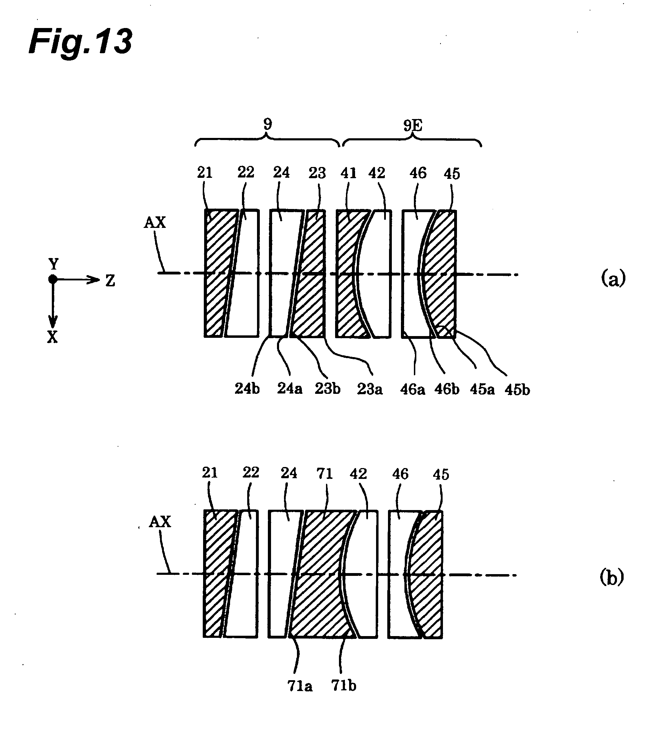

The above described use of the single polarization distribution adjusting member, but it is also possible to use two or more polarization distribution adjusting members. The following will describe such examples with reference to Fig. 13. Fig. 13 (a) is a drawing schematically showing a configuration of the polarization distribution adjusting members according to the seventh modification example. In the seventh modification example the polarization distribution adjusting members are a combination of the polarization distribution adjusting member 9 of the aforementioned embodiment with the polarization distribution adjusting member 9E of the fifth modification example. In this configuration, the polarization distribution adjusting member 9E of the fifth modification example can be replaced by any one of the polarization distribution adjusting members 9A, 9B, 9C, 9D, and 9F according to the first to fourth modification examples and the sixth modification example. In the seventh modification example, the first optical-rotation optical member 21 or 41 can be regarded, for example, as a first polarizing member and the second optical-rotation optical member 23 or 45 can be regarded, for example, as a second polarizing member.

Fig. 13 (b) is a drawing schematically showing a configuration of the polarization distribution adjusting members according to the eighth modification example. The polarization distribution adjusting members of the eighth modification example include an optical-rotation optical member 71 as an integration of the second optical-rotation optical member 23 in the polarization distribution adjusting member 9 and the first optical-rotation optical member 41 in the polarization distribution adjusting member 9E in the seventh modification example. In this configuration, the optical-rotation optical member 71, the second correction optical member 24, and the first correction optical member 42 are arranged as rotatable around the optical axis AX. In the eighth modification example, the first optical-rotation optical member 21 or the optical-rotation optical member 71 can be regarded, for example, as a first polarizing member and the second optical-rotation optical member 45 or the optical-rotation optical member 71 can be regarded, for example, as a second polarizing member.

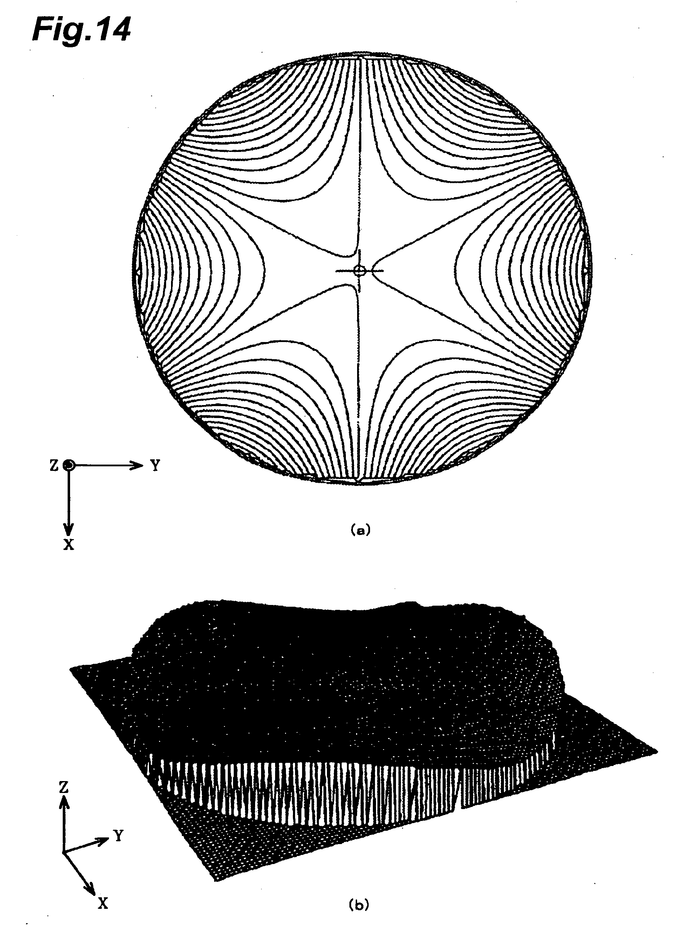

In the above description the optical-rotation optical members used were those with the thickness distribution of one-fold rotation symmetry or two-fold rotation symmetry with respect to the optical axis AX, but, without being limited to this, it is also possible to use optical-rotation optical members with a thickness distribution of any other rotation symmetry such as three- or more-fold rotation symmetry (except for infinite-fold rotation symmetry with respect to the rotation axis). Fig. 14 is a drawing schematically showing a thickness distribution of an optical-rotation optical member in the polarization distribution adjusting member according to the ninth modification example, wherein Fig. 14 (a) is a contour drawing and Fig. 14 (b) a bird's-eye view. In the ninth modification example shown in Fig. 14, the polarization distribution adjusting member is constructed by applying the optical-rotation optical member with a thickness distribution of three-fold rotation symmetry with respect to the rotation axis (optical axis AX) and this enables good correction for a $3\theta$ polarization state distribution when it is the polarization distribution to be corrected. This optical-rotation optical member in the ninth modification example is combined with a correction optical member with a thickness distribution complementary to this thickness distribution, though not shown.

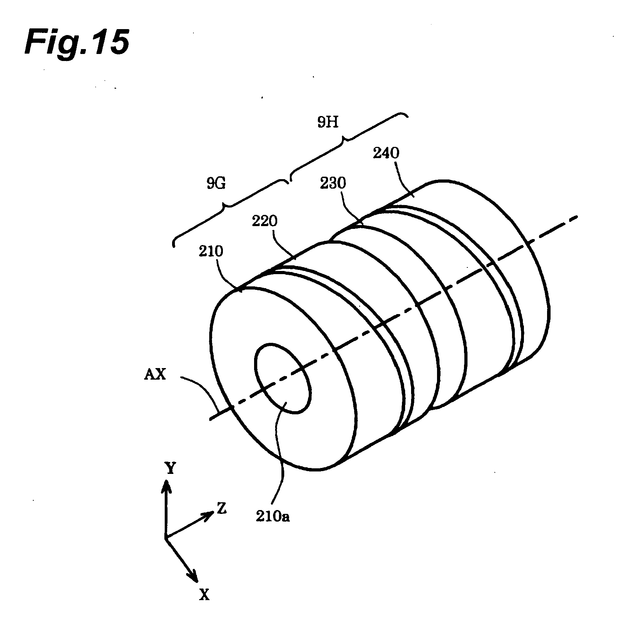

Fig. 15 is a drawing schematically showing a configuration of the polarization distribution adjusting member according to the tenth modification example. The polarization distribution adjusting member 9G + 9H (210, 220, 230, 240) in the tenth modification example is one obtained by forming an aperture near the optical axis (in proximity to the rotation axis) in the polarization distribution adjusting member 9 (21, 22, 23, 24) in the aforementioned embodiment. This configuration permits different polarization state changes to be given to light passing the aperture 210a in proximity to the optical axis and to light passing the periphery. In the tenth modification example, the first optical-rotation optical member 210 can be regarded, for example, as a first polarizing member and the second optical-rotation optical member 230 can be regarded, for example, as a second polarizing member.

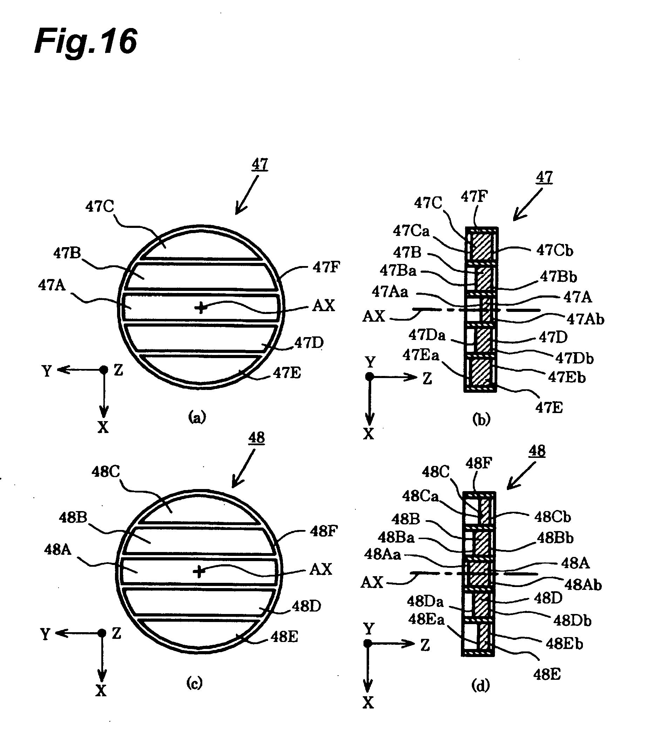

In the above description each optical-rotation optical member (polarizing member) in the polarization distribution adjusting member was formed of a single optical member, but it may also be composed of an aggregate of a plurality of optical-rotation optical elements. Fig. 16 is a drawing schematically showing configurations of polarization distribution adjusting members 47, 48 according to the eleventh modification example. Fig. 16 (a) is an XY plan view of the polarization distribution adjusting member 47 and Fig. 16 (b) an XZ sectional view of the polarization distribution adjusting member 47. Fig. 16 (c) is an XY plan view of the polarization distribution adjusting member 48 and Fig. 16 (d) an XZ sectional view of the polarization distribution adjusting member 48.

In Fig. 16 (a) and (b), the polarization distribution adjusting member 47 is provided with a plurality of optical-rotation optical elements 47A-47E having the longitudinal direction along a direction crossing the optical axis AX and having a plane-parallel plate shape, and a holding member 47F holding these optical-rotation optical elements 47A-47E in a stack along the transverse direction perpendicular to the longitudinal direction and being rotatable around the rotation axis (the optical axis AX in the present modification example).

The entire polarization distribution adjusting member 47 has an optical rotation distribution of rotation asymmetry (two-fold rotation symmetry in the present modification example) approximate to the optical rotation distribution of the polarization distribution adjusting member 41 in the fifth modification example shown in Fig. 11. For obtaining this optical rotation distribution, as shown in the sectional view of Fig. 16 (b), the optical-rotation optical element 47A positioned near the optical axis AX (the rotation axis in the present modification example) has the first thickness, the optical-rotation optical elements 47B, 47D positioned on both sides of this optical-rotation optical element 47A have the second thickness larger than the first thickness, and the optical-rotation optical elements 47C, 47E located outside the optical-rotation optical elements 47B, 47D have the third thickness larger than the second thickness of the optical-rotation optical elements 47B, 47D.

The polarization distribution adjusting member 48, as shown in Fig. 16 (c) and (d), is provided with a plurality of optical-rotation optical elements 48A-48E having the longitudinal direction along a direction crossing the optical axis AX and having a plane-parallel plate shape, and a holding member 48F holding these optical-rotation optical elements 48A-48E in a stack along the transverse direction perpendicular to the longitudinal direction and being rotatable around the rotation axis (the optical axis AX in the present modification example).

The entire polarization distribution adjusting member 48 has an optical rotation distribution of rotation asymmetry (two-fold rotation symmetry in the present modification example) approximate to the optical rotation distribution of the polarization distribution adjusting member 45 in the fifth modification example shown in Fig. 11. For obtaining this optical rotation distribution, as shown in the sectional view of Fig. 16 (d), the optical-rotation optical element 48A positioned near the optical axis AX (the rotation axis in the present modification example) has the fourth thickness, the optical-rotation optical elements 48B, 48D positioned on both sides of this optical-rotation optical element 48A have the fifth thickness smaller than the fourth thickness, and the optical-rotation optical elements 48C, 48E positioned outside the optical-rotation optical elements 48B, 48D have the sixth thickness smaller than the fifth thickness of the optical-rotation optical elements 48B, 48D. Namely, the optical rotation distribution of the entire polarization distribution adjusting member 48 is one complementary to that of the polarization distribution adjusting member 47.

It is noted herein that the following sums are equal to each other: the sum of the first thickness of the optical-rotation optical element 47A and the fourth thickness of the optical-rotation optical element 48A; the sum of the second thickness of the optical-rotation optical elements 47B, 47D and the fifth thickness of the optical-rotation optical elements 48B, 48D; the sum of the third thickness of the optical-rotation optical elements 47C, 47E and the sixth thickness of the optical-rotation optical elements 48C, 48E.

This configuration enables the eleventh modification example to achieve the function equivalent to that of the polarization distribution adjusting member shown in the fifth modification example. In the eleventh modification example shown in Fig. 16, each polarization distribution adjusting member is composed of five phase elements (optical-rotation optical elements), but the number of phase elements is not limited to five. For example, by increasing the number of phase optical elements, it becomes feasible to obtain a polarization distribution adjusting member with an optical rotation distribution approximate as a whole to the optical rotation distribution of the polarization distribution adjusting member in the third modification example of Fig. 9 or in the sixth modification example of Fig. 12. In the eleventh modification example, the aggregate of optical-rotation optical elements 47A-47E can be regarded as a first polarizing member and the aggregate of optical-rotation optical elements 48A-48E can be regarded, for example, as a second polarizing member.

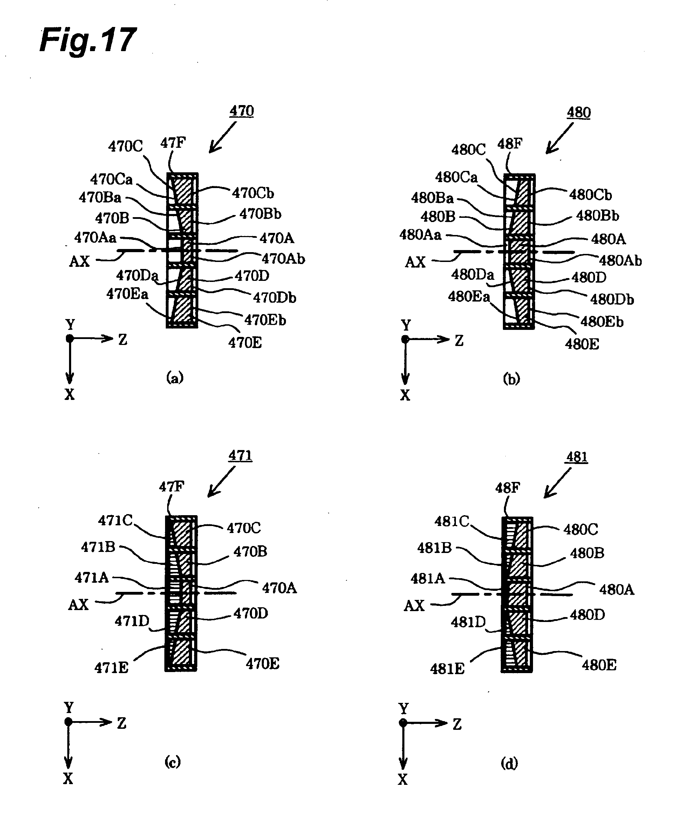

The above-described eleventh modification example used the plurality of optical-rotation optical elements of the plane-parallel plate shape, but the plurality of optical-rotation optical elements do not have to be limited to the plane-parallel plate shape. Fig. 17 (a) and (b) are sectional views schematically showing configurations of polarization distribution adjusting members 470, 480 according to the twelfth modification example. The polarization distribution adjusting member 470 in the twelfth modification example has an optical rotation distribution approximately similar to that of the polarization distribution adjusting member 47 in the eleventh modification example and is provided with a plurality of optical-rotation optical elements 470B-470E of a wedge shape, instead of the optical-rotation optical elements 47B-47E of the plane-parallel plate shape. The polarization distribution adjusting member 480 has an optical rotation distribution approximately similar to that of the polarization distribution adjusting member 48 in the eleventh modification example and is provided with a plurality of optical-rotation optical elements 480B-480E of a wedge shape, instead of the optical-rotation optical elements 48B-48E of the plane-parallel plate shape.

The accuracy of approximation of optical rotation distribution can be improved by using the optical-rotation optical elements 470B-470E, 480B-480E of the wedge shape instead of those of the plane-parallel plate shape. The entrance surfaces 470Aa-470Ea, 480Aa-480Ea of these optical-rotation optical elements 470A-470E, 480A-480E may be changed from the planar shape into a curved shape such as a concave cylindrical surface or a convex cylindrical surface. In the twelfth modification example, the aggregate of optical-rotation optical elements 470A-470E can be regarded as a first polarizing member and the aggregate of optical-rotation optical elements 480A-480E can be regarded, for example, as a second polarizing member.

In cases where the polarization distribution adjusting member is constructed using the optical-rotation optical elements of the shapes other than the plane-parallel plate shape, e.g., those of the wedge shape or curved shape, it is preferable to combine the optical-rotation optical elements with correction optical elements having faces complementary to those of the optical-rotation optical elements of the shapes other than the plane-parallel plate shape, as in the thirteenth modification example of Fig. 17 (c) and (d).

Fig. 17 (c) shows a polarization distribution adjusting member 471 in the thirteenth modification example as a combination of the plurality of optical-rotation optical elements 470A-470E of the polarization distribution adjusting member 470 in the twelfth modification example shown in Fig. 17 (a), with correction optical elements 471A-471E. As shown in Fig. 17 (c), each of the optical-rotation optical elements 470A-470E and each of the correction optical elements 471A-471E are housed in the holding member 47F so that they have a form of the plane-parallel plate shape as a whole.

Fig. 17 (d) shows a polarization distribution adjusting member 481 in the thirteenth modification example as a combination of the plurality of optical-rotation optical elements 480A-480E of the polarization distribution adjusting member 480 in the twelfth modification example shown in Fig. 17 (b), with correction optical elements 481A-481E. As shown in Fig. 17 (d), each of the optical-rotation optical elements 480A-480E and each of the correction optical elements 481A-481E are housed in the holding member 48F so that they have a form of the plane-parallel plate shape as a whole.

In the thirteenth modification example, as described above, each set of an optical-rotation optical element and a correction optical element has the form of the plane-parallel plate shape as a whole, and thus they can maintain the traveling direction of light passing through the polarization distribution adjusting members 471, 481. In the thirteenth modification example, the aggregate of optical-rotation optical elements 470A-470E can be regarded as a first polarizing member, and the aggregate of optical-rotation optical elements 480A-480E can be regarded, for example, as a second polarizing member.

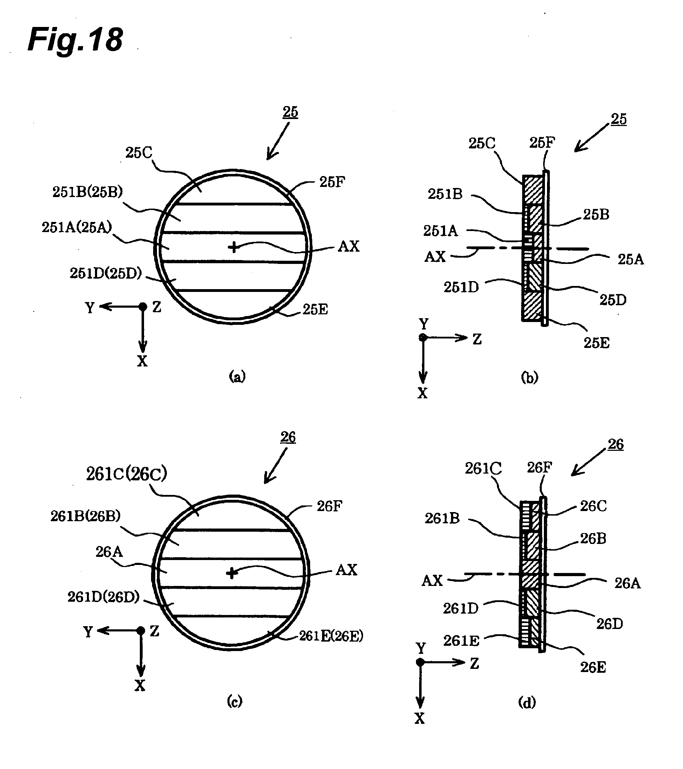

The twelfth modification example and the thirteenth modification example described above showed the examples in which the plurality of optical-rotation optical elements (and correction optical elements) were held by the holding member, but, without being limited to this configuration, the plurality of optical-rotation optical elements may also be arrayed on a single optically transparent substrate. Fig. 18 is a drawing schematically showing configurations of polarization distribution adjusting members 25, 26 according to the fourteenth modification example.

Fig. 18 (a) and (b) are views schematically showing the configuration of the polarization distribution adjusting member 25 according to the fourteenth modification example and Fig. 18 (c) and (d) are views schematically showing the configuration of the polarization distribution adjusting member 26 according to the fourteenth modification example.

Fig. 18 (a) is a plan view of the polarization distribution adjusting member 25, Fig. 18 (b) a sectional view of the polarization distribution adjusting member 25, Fig. 18 (c) a plan view of the polarization distribution adjusting member 26, and Fig. 18 (d) a sectional view of the polarization distribution adjusting member 26.

In Fig. 18 (a) and (b), the polarization distribution adjusting member 25 is provided with a plurality of optical-rotation optical elements 25A-25E having the longitudinal direction along a direction crossing the optical axis AX and having a plane-parallel plate shape, and a holding substrate 25F holding the plurality of optical-rotation optical elements 25A-25E in a stack along the transverse direction perpendicular to the longitudinal direction and being rotatable around the rotation axis (the optical axis AX in the present modification example). The holding substrate 25F is made of an optically transparent amorphous optical material, e.g., silica glass, and the plurality of optical-rotation optical elements 25A-25E are fixed on this holding substrate 25F by such a technique as the optical contact. The whole polarization distribution adjusting member 25 has an optical rotation distribution of rotation asymmetry (two-fold rotation symmetry in the present modification example) equivalent to the optical rotation distribution of the polarization distribution adjusting member 47 in the eleventh modification example shown in Fig. 16.

The polarization distribution adjusting member 26, as shown in Fig 8 (c) and (d), is provided with a plurality of optical-rotation optical elements 26A-26E having the longitudinal direction along a direction crossing the optical axis AX and having the plane-parallel plate shape, and a holding member 26F holding these optical-rotation optical elements 26A-26E in a stack along the transverse direction perpendicular to the longitudinal direction and being rotatable around the rotation axis (the optical axis AX in the present modification example). The holding substrate 26F herein is also made of an optically transparent amorphous optical material, e.g., silica glass, and the plurality of optical-rotation optical elements 26A-26E are fixed on the holding substrate 26F by such a technique as the optical contact.

In the fourteenth modification example, in order to keep the thickness approximately constant in the direction of the optical axis AX of the polarization distribution adjusting members, correction optical members 251A, 251B, 251D are provided on the respective optical-rotation optical elements 25A, 25B, 25D, and correction optical members 261B-261E are provided on the respective optical-rotation optical elements 26B-26E. The whole polarization distribution adjusting member 26 has an optical rotation distribution of rotation asymmetry (two-fold rotation symmetry in the present modification example) equivalent to the optical rotation distribution of the polarization distribution adjusting member 48 in the eleventh modification example shown in Fig. 16.

In the fourteenth modification example shown in Fig. 18, the configuration of the optical-rotation optical elements 25A-25E, 26A-26E integrated along one direction crossing the optical axis AX is much the same as the configuration of the optical-rotation optical elements 47A-47E, 48A-48E, respectively, shown in the eleventh modification example, and thus the description thereof is omitted herein. The fourteenth modification example achieves the function equivalent to that of the polarization distribution adjusting members shown in the eleventh modification example.

In the fourteenth modification example shown in Fig. 18, each polarization distribution adjusting member is composed of five phase elements (optical-rotation optical elements), but the number of phase elements is not limited to five. For example, by increasing the number of phase optical elements, it becomes feasible to obtain a polarization distribution adjusting member with an optical rotation distribution approximate as a whole to the optical rotation distribution of the polarization distribution adjusting member in the third modification example of Fig. 9 or in the sixth modification example of Fig. 12.

In the fourteenth modification example shown in Fig. 18, the plurality of optical-rotation optical elements (phase elements) are not limited to the plane-parallel plate shape, but may have a wedge shape as in the twelfth and thirteenth modification examples or may have a curved shape. In the fourteenth modification example, the aggregate of optical-rotation optical elements 25A-25E can be regarded as a first polarizing member and the aggregate of optical-rotation optical elements 26A-26E can be regarded, for example, as a second polarizing member.

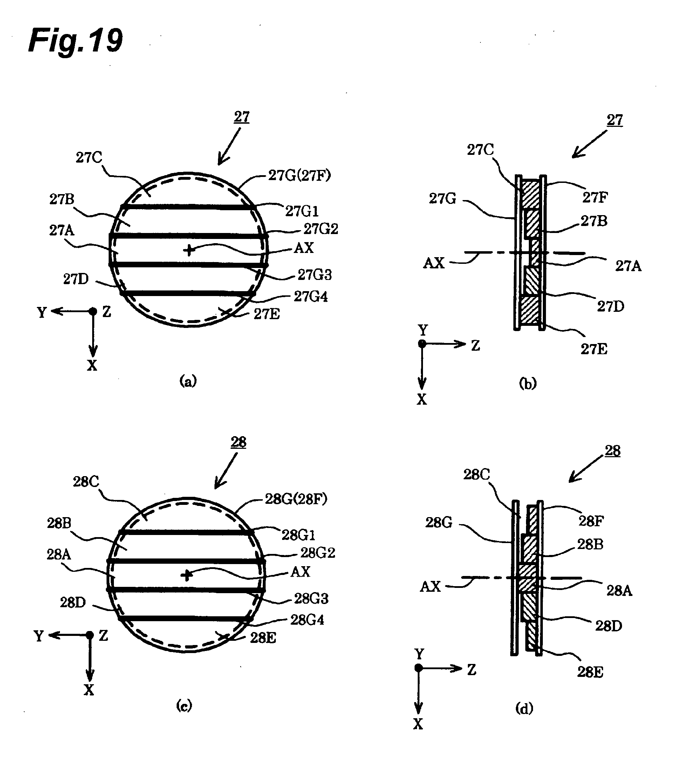

In the fourteenth modification example the plurality of optical-rotation optical elements (polarizing optical elements) 25A-25E, 26A-26E were integrated on one optically transparent substrate 25F, 26F, but the plurality of optical-rotation optical elements (polarizing optical elements) may be held so as to be sandwiched between two optically transparent substrates. Fig. 19 is a drawing schematically showing configurations of polarization distribution adjusting members 27, 28 according to the fifteenth modification example, wherein Fig. 19 (a) and (b) are views schematically showing the configuration of the polarization distribution adjusting member 27 according to the fifteenth modification example and Fig. 19 (c) and (d) are views schematically showing the configuration of the polarization distribution adjusting member 28 according to the fifteenth modification example. Fig. 19 (a) is a plan view of the polarization distribution adjusting member 27, Fig. 19 (b) a sectional view of the polarization distribution adjusting member 27, Fig. 19 (c) a plan view of the polarization distribution adjusting member 28, and Fig. 19 (d) a sectional view of the polarization distribution adjusting member 28.

In the fifteenth modification example, the configurations of the plurality of optical-rotation optical elements 27A-27E, 28A-28E integrated along one direction crossing the optical axis AX are the same as those of the plurality of optical-rotation optical elements 25A-25E, 26A-26E shown in the fourteenth modification example, and the description thereof is omitted herein.

The fifteenth modification example is different in the configuration from the fourteenth modification example in that the plurality of optical-rotation optical elements 27A-27E are sandwiched between two optically transparent substrates 27F, 27G arranged in juxtaposition along the direction of the optical axis AX and in that the plurality of optical-rotation optical elements 28A-28E are sandwiched between two optically transparent substrates 28F, 28G arranged in juxtaposition along the direction of the optical axis AX. The optically transparent substrates 27G, 28G in the fifteenth modification example are provided with shield portions 27G1-27G4, 28G1-28G4 so as to overlap the optical-rotation optical elements 27A-27E, 28A-28E, in order to prevent unwanted light which could appear in the boundary regions of the optical-rotation optical elements 27A-27E, 28A-28E. This configuration achieves uniform illumination while preventing the unwanted light from the boundary regions of the optical-rotation optical elements (polarizing optical elements).

In the fifteenth modification example, each optical-rotation optical element may also be provided with a correction optical element as in the aforementioned fourteenth modification example and the shape of each optical-rotation optical element may be a wedge shape. In the fifteenth modification example, the aggregate of optical-rotation optical elements 27A-27E can be regarded as a first polarizing member and the aggregate of optical-rotation optical elements 28A-28E can be regarded, for example, as a second polarizing member.

In the eleventh to fifteenth modification examples, the plurality of optical-rotation optical elements (phase elements or polarizing optical elements) were integrated in one direction in the plane crossing the optical axis, but the direction of integration of the optical-rotation optical elements is not limited to only one direction; for example, they may also be integrated in a two-dimensional matrix.

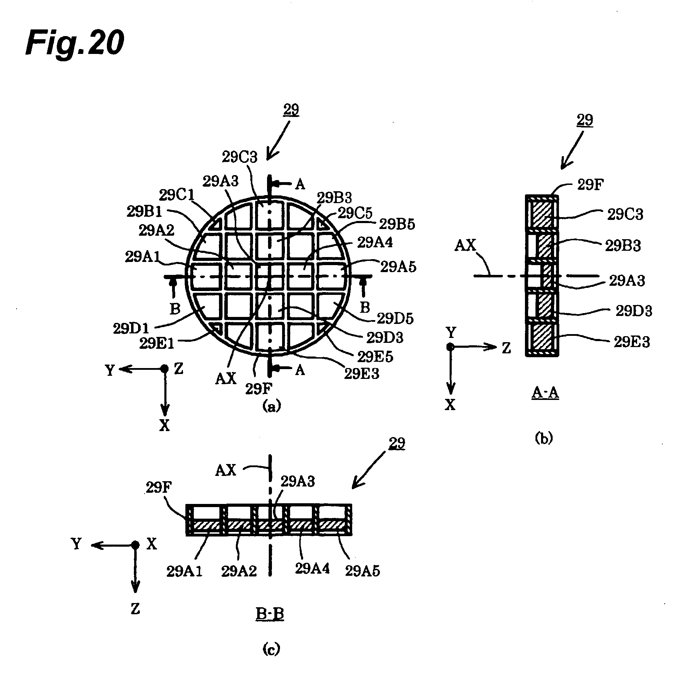

Fig. 20 is a drawing schematically showing a configuration of a polarization distribution adjusting member 29 according to the sixteenth modification example, in which a plurality of optical-rotation optical elements (phase elements or polarizing optical elements) are arrayed in a two-dimensional matrix (array form) in the plane crossing the optical axis, wherein Fig. 20 (a) is a plan view (XY plan view), Fig. 20 (b) an A-A arrow view (XZ sectional view), and Fig. 20 (c) a B-B arrow view (YZ sectional view).

In Fig. 20 (a) to (c), the polarization distribution adjusting member 29 is provided with a plurality of optical-rotation optical elements 29A1-29E5 arranged in the XY plane crossing the optical axis AX, and a holding member 29F holding these optical-rotation optical elements 29A1-29E5 in a two-dimensional array form in the XY plane and being rotatable around the rotation axis (the optical axis AX in the present modification example).

As apparent from the A-A arrow view of Fig. 20 (b) and the B-B arrow view of Fig. 20 (c), the optical-rotation optical elements 29A1-29A5 arrayed along a first axis passing near the optical axis and extending along the Y-direction in the drawing have the first thickness along the optical-axis direction, the optical-rotation optical elements 29B1-B5 arrayed along a second axis adjacent and parallel to the first axis have the second thickness larger than the first thickness, and the optical-rotation optical elements 29D1-D5 arrayed along a third axis located on the opposite side to the second axis with respect to the first axis, and being parallel to the first axis have the second thickness. Furthermore, the optical-rotation optical elements 29C1-29C5 arrayed along a fourth axis located outside the second axis and extending in parallel with the first axis, and the optical-rotation optical elements 29E1-29E5 arrayed along a fifth axis located outside the third axis and extending in parallel with the first axis have the third thickness larger than the second thickness.

The whole polarization distribution adjusting member 29 has an optical rotation distribution equivalent to that of the polarization distribution adjusting member 47 in the eleventh modification example shown in Fig. 16 (a) and (b). In the sixteenth modification example, the row of optical-rotation optical elements along each axis (the first to fifth axes) were the optical-rotation optical elements with the same thickness in the direction of the optical axis AX, but it is also possible to adopt a configuration wherein the plurality of optical-rotation optical elements arrayed along each axis have different thicknesses to achieve a two-dimensional optical rotation distribution in the plane crossing the optical axis. In the sixteenth modification example the plurality of optical-rotation optical elements were arrayed in the matrix of 5×5, but the matrix does not have to be limited to 5×5.

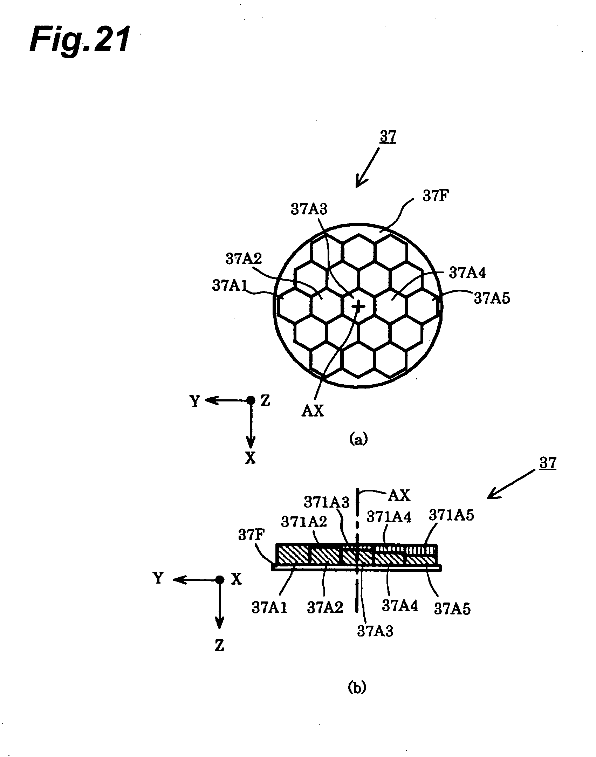

In the above-described sixteenth modification example, the shape of each of the optical-rotation optical elements (phase elements or polarizing elements) was the rectangular shape, but the shape of the optical-rotation optical elements (phase elements or polarizing elements) is not limited to the rectangular shape; for example, they may have a hexagonal shape as in the seventeenth modification example shown in Fig. 21.

Fig. 21 is a drawing showing a schematic configuration of the polarization distribution adjusting member 37 according to the seventeenth modification example, wherein Fig. 21 (a) is a plan view of the polarization distribution adjusting member 37 according to the seventeenth modification example and Fig. 21 (b) a sectional view thereof. The polarization distribution adjusting member 37 of the seventeenth modification example has an optical rotation distribution approximately similar to that of the polarization distribution adjusting member 29 of the sixteenth modification example shown in Fig. 20.

In Fig. 21 (a) and (b), the seventeenth modification example is different in the configuration from the sixteenth modification example shown in Fig. 20, in that the contour of each optical-rotation optical element 37A1-37A5 is hexagonal and in that the optical-rotation optical elements with corresponding correction optical elements 371A2-371A5 are integrated on an optically transparent substrate 37F like the polarization distribution adjusting members 25, 26 in the fourteenth modification example.

The polarization distribution adjusting members 29, 37 of the sixteenth modification example and the seventeenth modification example described above had the optical rotation distribution varying only in one predetermined direction crossing the optical axis AX, but they may have a two-dimensional distribution in the plane crossing the optical axis AX, for example, as in the ninth modification example of Fig. 14.

The contour of each optical-rotation optical element (phase element or polarizing element) does not have to be limited to the rectangular or hexagonal shape, but may be any other polygonal shape. However, in order to minimize light-quantity loss, it is preferable to adopt a shape permitting close packing arrangement, e.g., the rectangular shape or the hexagonal shape. The shape of the optical-rotation optical elements does not have to be limited to the same shape, but it is also possible to adopt a combination of shapes permitting close packing arrangement, e.g., a combination of a regular pentagon with a rhombus, a combination of a regular heptagon with a pentagon, or a combination of a regular octagon with a square.

Since light-quantity unevenness is likely to occur in the boundary regions of the optical-rotation optical elements (phase elements or polarizing elements) as in the aforementioned eleventh to seventeenth modification examples, it is preferable to reduce the influence of the boundary regions, for example, by defocusing the polarization distribution adjusting member somewhat from the plane optically conjugate with the illumination pupil plane or from the plane optically conjugate with the surface to be illuminated.

In the above description the polarization distribution on the illumination pupil plane is adjusted by locating the polarization distribution adjusting member at the position immediately before the micro fly's eye lens 10. However, without being limited to this, the polarization distribution on the illumination pupil plane can also be adjusted by locating the polarization distribution adjusting member at or near the pupil position of the illumination optical apparatus (1-PL), e.g., at or near the pupil 61 of the afocal lens 5, at or near the pupil of the imaging optical system 13, or at one of a position immediately before, a position 62 immediately after, and a position near the micro fly's eye lens 10.

In the above description, the polarization distribution adjusting member includes the first polarizing member (first optical-rotation optical member 21, 31, 41, 51) and the second polarizing member (second optical-rotation optical member 23, 33, 43, 53) arranged adjacent to each other on the illumination optical path, but, without being limited to this, they may also be arranged so as to be approximately conjugate with each other through an optical system in the illumination optical apparatus. For example, the first polarizing member may be located at or near the pupil 61 of the afocal lens 5 and the second optical member may be located at one of the position immediately before, the position 62 immediately after, and the position near the micro fly's eye lens 10, or at or near the pupil of the imaging optical system 13.

When the polarizing member of the first set (e.g., the set of first optical-rotation optical member 21, 31, 41, 51 and correction optical member 22, 32, 42, 52) is different in the configuration from the polarizing member of the second set (e.g., the set of second optical-rotation optical member 23, 33, 43, 53 and correction optical member 24, 34, 44, 54), these sets of polarizing members may be arranged adjacent to each other in the illumination optical path, or, without being limited to this, they may also be arranged so as to be approximately conjugate with each other through an optical system in the illumination optical apparatus.

In order to adjust the polarization distribution on the illumination pupil plane, the polarization distribution adjusting member is preferably located in the portion of the beam where the sectional shape thereof is changed by the beam shape changing member. In this case, it is preferable to locate the polarization state switch for adjusting the polarization state of the entire beam cross section nearer to the light source than the beam shape changing member. This configuration permits the polarization state switch to adjust the overall offset component in the polarization state on the illumination pupil plane, and permits the polarization distribution adjusting member to adjust the distribution of local polarization states in the illumination pupil plane.

In the above description, the polarization distribution adjusting member is located at or near the pupil position of the illumination optical apparatus (1-PL) to adjust the polarization distribution on the illumination pupil plane. However, without being limited to this, it is also possible to adjust the polarization distribution on the wafer W being a surface to be illuminated, by locating the polarization distribution adjusting member at or near the position optically conjugate with the surface to be illuminated (W) in the illumination optical apparatus (1-PL). In this case, specifically, the polarization distribution adjusting member is located, for example, at a position 65 immediately before and/or at a position 66 immediately after the mask M, at a position 63 immediately before or at a position 64 immediately after the mask blind 12, or at a position 67 immediately before the wafer W. The polarization distribution adjusting member is preferably located in the optical path between the micro fly's eye lens as a wavefront-splitting type optical integrator, and the surface to be illuminated. It is also possible to locate two polarization distribution adjusting members one at or near the pupil position of the illumination optical apparatus (1-PL) and the other at or near the position optically conjugate with the surface to be illuminated (W) in the illumination optical apparatus (1-PL). It is also possible, for example, to locate the polarization distribution adjusting member at a position 68 different from the pupil position of the illumination optical apparatus (1-PL) and the position optically conjugate with the surface to be illuminated (W).

In the case of the scan type (scanning) exposure apparatus, the polarization distribution along an orthogonal direction perpendicular to a scanning direction is more important than the polarization distribution along the scanning direction in a still exposure region on the wafer W being a surface to be illuminated, by virtue of scan averaging effect. Therefore, when the polarization distribution adjusting member in each of the aforementioned embodiment and modification examples is applied to the scan type exposure apparatus, the first set of optical-rotation optical member and correction optical member and the second set of optical-rotation optical member and correction optical member had better be rotated by the same angle in opposite directions, so as to adjust only the polarization distribution along the orthogonal direction.

In the above description, the configuration from the light source 1 to the projection optical system PL is assumed to constitute the illumination optical apparatus for illuminating the wafer W as the surface to be illuminated, but we can also assume that the configuration from the light source 1 to the imaging optical system 13 constitutes an illumination optical apparatus for illuminating the mask M as a surface to be illuminated. In this case, the polarization distribution adjusting member for adjusting the polarization distribution on the mask M as a surface to be illuminated is located near the surface to be illuminated (M) in the illumination optical apparatus (1-13), or at or near a position optically conjugate with the surface to be illuminated (M).

In the above description, the optical rotation members (optical-rotation optical members) for providing the incident light with optical rotation amounts varying according to respective positions of incidence were rotated, but in general, it is feasible to adjust the polarization distribution of light on the illumination pupil plane or on the surface to be illuminated, by rotating a phase member for providing the incident light with phase amounts varying according to respective positions of incidence. This phase member may be an optical rotation member for providing phase differences different according to respective directions of rotation of circularly polarized light (i.e., for providing a required optical rotation distribution for linearly polarized light to be resolved into left-hand and right-hand circularly polarized light components with an equal amplitude and equal velocity), like the optical-rotation optical members in the aforementioned embodiment and each modification example. This phase member may be a phase shift member for providing phase differences different according to respective directions of vibration of linearly polarized light, e.g., like a wave plate. This phase shift member may be one made of a birefringent optical material such as rock crystal, may be one of a shape to exhibit form birefringence, or may be an optical member with stress birefringence. It is also possible to use a combination of an optical rotation member with a phase shift member.

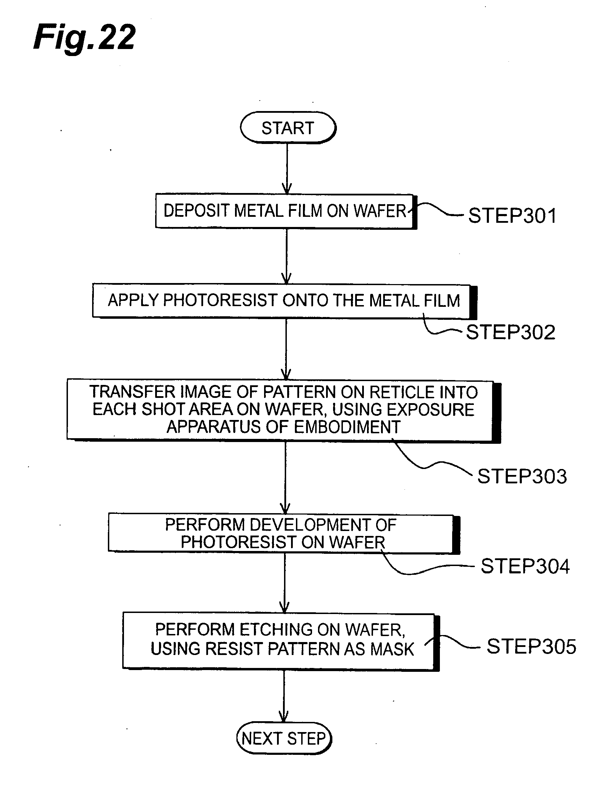

The exposure apparatus according to the above-described embodiment can manufacture micro devices (semiconductor devices, imaging devices, liquid-crystal display devices, thin-film magnetic heads, etc.) through a process of illuminating a mask (reticle) by the illumination optical apparatus (illumination step) and exposing a photosensitive substrate with a transfer pattern formed in a mask, by the projection optical system (exposure step). An example of a method for obtaining semiconductor devices as micro devices by forming a predetermined circuit pattern in a wafer or the like as a photosensitive substrate by means of the exposure apparatus of the above embodiment will be described below with reference to the flowchart of Fig. 22.

The first step 301 in Fig. 22 is to deposit a metal film on each wafer in one lot. The next step 302 is to apply a photoresist onto the metal film on each wafer in the lot. The subsequent step 303 is to use the exposure apparatus of the above embodiment to sequentially transfer an image of a pattern on a mask into each shot area on each wafer in the lot through the projection optical system of the exposure apparatus. The subsequent step 304 is to perform development of the photoresist on each wafer in the lot and the next step 305 is to perform etching using the resist pattern on each wafer in the lot as a mask, and thereby to form a circuit pattern corresponding to the pattern on the mask, in each shot area on each wafer. Thereafter, devices such as semiconductor devices are manufactured through steps including formation of circuit patterns in upper layers. The above-described semiconductor device manufacturing method permits us to obtain the semiconductor devices with extremely fine circuit patterns at high throughput.

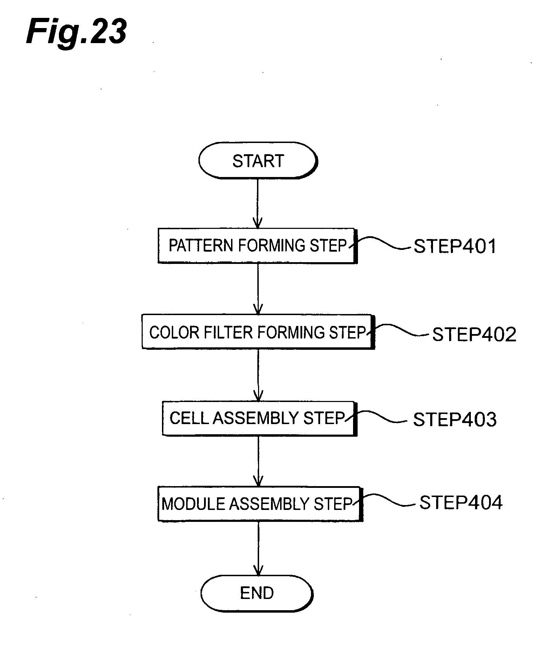

The exposure apparatus of the above embodiment can also manufacture a liquid-crystal display device as a micro device by forming predetermined patterns (circuit pattern, electrode pattern, etc.) on plates (glass substrates). An example of a method in this case will be described below with reference to the flowchart of Fig. 23. In Fig. 23, a pattern forming step 401 is to execute the so-called photolithography step for transferring a pattern of a mask onto a photosensitive substrate (a glass substrate coated with a resist or the like) by means of the exposure apparatus of the above embodiment. This photolithography step results in forming a predetermined pattern including a large number of electrodes and others on the photosensitive substrate. Thereafter, the exposed substrate is processed through each of steps including a development step, an etching step, a resist removing step, etc. whereby the predetermined pattern is formed on the substrate, followed by the next color filter forming step 402.

The next color filter forming step 402 is to form a color filter in which a large number of sets of three dots corresponding to R (Red), G (Green), and B (Blue) are arrayed in a matrix pattern or in which sets of filters of three stripes of R, G, and B are arrayed in the horizontal scan line direction. After the color filter forming step 402, a cell assembling step 403 is executed. The cell assembling step 403 is to assemble a liquid crystal panel (liquid crystal cell) using the substrate with the predetermined pattern obtained in the pattern forming step 401, the color filter obtained in the color filter forming step 402, and others.

In the cell assembling step 403, the liquid crystal panel (liquid crystal cell) is manufactured, for example, by pouring a liquid crystal into between the substrate with the predetermined pattern obtained in the pattern forming step 401 and the color filter obtained in the color filter forming step 402. The subsequent module assembling step 404 is to attach various components such as electric circuits and a backlight for display operation of the assembled liquid crystal panel (liquid crystal cell) to complete the liquid-crystal display device. The above-described manufacturing method of the liquid-crystal display device permits us to obtain the liquid-crystal display device with extremely fine circuit patterns at high throughput.

The aforementioned embodiment used the ArF excimer laser light (the wavelength: 193 nm) or the KrF excimer laser light (the wavelength: 248 nm) as the exposure light, but the exposure light does not have to be limited to these: the present invention can also be applied to any other appropriate laser light source, e.g., an $F_2$ laser light source for supplying the laser light at the wavelength of 157 nm.

The foregoing embodiment was the application of the present invention to the illumination optical apparatus for illuminating the mask or the wafer in the exposure apparatus, but, without having to be limited to this, the present invention can also be applied to commonly-used illumination optical apparatus for illuminating a surface to be illuminated except for the mask or the wafer.

**Claims**

1. An illumination optical apparatus which illuminates a surface to be illuminated on the basis of light from a light source, comprising:

   a first polarizing member arranged as rotatable around an optical axis of the illumination optical apparatus or around an axis substantially parallel to the optical axis; and
   a second polarizing member arranged as rotatable around the optical axis or around said axis substantially parallel thereto in an optical path between the first polarizing member and the surface to be illuminated,

   wherein each of the first polarizing member and the second polarizing member provides incident light with variations in a polarization state different according to respective positions of incidence.

2. The illumination optical apparatus according to claim 1, further comprising a beam shape changing member disposed in an optical path between the light source and the first polarizing member and adapted to change a beam sectional shape of the light from the light source.

3. The illumination optical apparatus according to claim 2, wherein the beam shape changing member can be inserted and retracted the optical path between the light source and the first polarizing member.

4. The illumination optical apparatus according to any one of claims 1 to 3, wherein at least one of the first polarizing member and the second polarizing member is located at or near a pupil plane of the illumination optical apparatus.

5. The illumination optical apparatus according to any one of claims 1 to 4, wherein at least one of the first polarizing member and the second polarizing member is located near the surface to be illuminated, at a position optically conjugate with the surface to be illuminated, or near said conjugate position.

6. The illumination optical apparatus according to claim 5, further comprising an optical integrator disposed in an optical path between the light source and, the first polarizing member and the second polarizing member.

7. The illumination optical apparatus according to any one of claims 1 to 6, wherein at least one of the first polarizing member and the second polarizing member comprises a phase member which provides the incident light with phase amounts varying according to the respective positions of incidence.

8. The illumination optical apparatus according to claim 7, wherein the phase member is made of a birefringent material.

9. The illumination optical apparatus according to claim 7 or 8, wherein the phase member comprises a phase shift member which provides phase differences different according to respective directions of vibration of linearly polarized light.

10. The illumination optical apparatus according to any one of claims 7 to 9, wherein the phase member comprises an optical rotation member which provides phase differences different according to respective directions of rotation of circularly polarized light.

11. The illumination optical apparatus according to claim 10, wherein the optical rotation member is movable in a direction intersecting with the optical axis.

12. The illumination optical apparatus according to claim 10 or 11, wherein the optical rotation member comprises a first optical-rotation optical member made of an optically active material and with thickness in a direction of the optical axis varying along a predetermined direction perpendicular to the optical axis.

13. The illumination optical apparatus according to claim 12, wherein the first optical-rotation optical member includes a first face of a planar shape substantially perpendicular to the optical axis, and a second face of a surface shape substantially different from a plane perpendicular to the optical axis.

14. The illumination optical apparatus according to claim 13, wherein the optical rotation member comprises a first correction optical member including a third face formed in a surface shape complementary to the second face of the first optical-rotation optical member and located in proximity to the second face, and a fourth face of a planar shape substantially perpendicular to the optical axis, and
wherein the first optical-rotation optical member and the first correction optical member are integrally held.

15. The illumination optical apparatus according to claim 13 or 14, wherein the optical rotation member comprises a second optical-rotation optical member made of an optically active material and including a fifth face of a planar shape substantially perpendicular to the optical axis, and a sixth face of a surface shape complementary to the second face of the first optical-rotation optical member.

16. The illumination optical apparatus according to claim 15, wherein the optical rotation member comprises a second correction optical member including a seventh face formed in a surface shape complementary to the sixth face of the second optical-rotation optical member and located in proximity to the sixth face, and an eighth face of a planar shape substantially perpendicular to the optical axis, and
wherein the second optical-rotation optical member and the second correction optical member are integrally held.

17. The illumination optical apparatus according to any one of claims 7 to 16, wherein a distribution of the phase amounts of the phase member is a rotationally asymmetric distribution around a rotation axis of the phase member.

18. The illumination optical apparatus according to claim 17, wherein the rotationally asymmetric distribution is an n-fold rotationally symmetric distribution around the rotation axis, where n is an integer.

19. The illumination optical apparatus according to any one of claims 7 to 18, wherein a distribution of the phase amounts of the phase member includes a linear component linearly varying along a direction crossing the optical axis.

20. The illumination optical apparatus according to any one of claims 17 to 19, wherein the distribution of the phase amounts of the phase member includes an nth-order curved surface component rotationally asymmetric with respect to the rotation axis.

21. The illumination optical apparatus according to any one of claims 7 to 20, wherein the phase member comprises a plurality of phase elements arranged in a plane crossing a rotation axis of the phase member.

22. The illumination optical apparatus according to claim 21, wherein the plurality of phase elements comprise phase shift elements which provides phase differences different according to respective directions of vibration of linearly polarized light.

23. The illumination optical apparatus according to claim 21 or 22, wherein the plurality of phase elements comprise optical rotation elements which provides phase differences different according to respective directions of rotation of circularly polarized light.

24. The illumination optical apparatus according to any one of claims 21 to 23, wherein the plurality of phase elements have a form of a plane-parallel plate shape.

25. The illumination optical apparatus according to any one of claims 21 to 24, wherein a total phase amount distribution of the plurality of phase elements is a distribution rotationally asymmetric around the rotation axis in a plane crossing the rotation axis of the phase member.

26. The illumination optical apparatus according to any one of claims 1 to 25, wherein the first polarizing member and the second polarizing member are arranged as adjacent to each other.

27. The illumination optical apparatus according to any one of claims 1 to 26, wherein a rotation axis of the first polarizing member and a rotation axis of the second polarizing member are coaxial with each other.

28. The illumination optical apparatus according to claim 27, wherein the rotation axis of the first polarizing member and the rotation axis of the second polarizing member are coincident with the optical axis.

29. The illumination optical apparatus according to any one of claims 1 to 28, wherein at least one of the first polarizing member and the second polarizing member is arranged as retractable from an illumination optical path to the outside thereof.

30. The illumination optical apparatus according to any one of claims 1 to 29, wherein at least one of the first polarizing member and the second polarizing member is movable in a direction crossing an illumination optical path.

31. The illumination optical apparatus according to any one of claims 1 to 30, wherein at least one of the first polarizing member and the second polarizing member is tiltable relative to the optical axis.

32. An illumination optical apparatus which illuminates a surface to be illuminated on the basis of light from a light source, comprising:

   a phase member arranged as rotatable around an optical axis of the illumination optical apparatus or around an axis substantially parallel to the optical axis, at or near a pupil plane of the illumination optical apparatus, and adapted to provide incident light with phase amounts varying according to respective positions of incidence.

33. An illumination optical apparatus which illuminates a surface to be illuminated on the basis of light from a light source, comprising:

   a phase member arranged as rotatable around an optical axis of the illumination optical apparatus or around an axis substantially parallel to the optical axis, near the surface to be illuminated, at a position optically conjugate with the surface to be illuminated, or near said conjugate position, and adapted to provide incident light with phase amounts varying according to respective positions of incidence.

34. The illumination optical apparatus according to claim 32 or 33, wherein the phase member comprises a phase shift member which provides phase differences different according to respective directions of vibration of linearly polarized light.

35. The illumination optical apparatus according to claim 32 or 33, wherein the phase member comprises an optical rotation member which provides phase differences different according to respective directions of rotation of circularly polarized light.

36. An illumination optical apparatus which illuminates a surface to be illuminated on the basis of light from a light source, comprising:

   a polarization distribution adjusting member which adjusts a polarization distribution of light on an illumination pupil plane,

   wherein the polarization distribution adjusting member comprises an optical rotation member arranged as rotatable around an optical axis of the illumination optical apparatus or around an axis substantially parallel to the optical axis and adapted to provide incident light with optical rotation amounts varying according to respective positions of incidence.

37. An illumination optical apparatus which illuminates a surface to be illuminated on the basis of light from a light source, comprising:

a polarization distribution adjusting member which adjusts a polarization distribution of light on the surface to be illuminated,

wherein the polarization distribution adjusting member comprises an optical rotation member arranged as rotatable around an optical axis of the illumination optical apparatus or around an axis substantially parallel to the optical axis and adapted to provide incident light with optical rotation amounts varying according to respective positions of incidence.

38. The illumination optical apparatus according to any one of claims 35 to 37, wherein the optical rotation member is movable in a direction intersecting with the optical axis.

39. The illumination optical apparatus according to any one of claims 35 to 38, wherein the optical rotation member comprises a first optical-rotation optical member made of an optically active material and with thickness in a direction of the optical axis varying along a predetermined direction perpendicular to the optical axis.

40. The illumination optical apparatus according to claim 39, wherein the first optical-rotation optical member includes a first face of a planar shape substantially perpendicular to the optical axis, and a second face of a surface shape substantially different from a plane perpendicular to the optical axis.

41. The illumination optical apparatus according to claim 40, wherein the optical rotation member comprises a first correction optical member including a third face formed in a surface shape complementary to the second face of the first optical-rotation optical member and located in proximity to the second face, and a fourth face of a planar shape substantially perpendicular to the optical axis, and
wherein the first optical-rotation optical member and the first correction optical member are integrally held.

42. The illumination optical apparatus according to claim 40 or 41, wherein the optical rotation member comprises a second optical-rotation optical member made of an optically active material and including a fifth face of a planar shape substantially perpendicular to the optical axis, and a sixth face of a surface shape complementary to the second face of the first optical-rotation optical member.

43. The illumination optical apparatus according to claim 42, wherein the optical rotation member comprises a second correction optical member including a seventh face formed in a surface shape complementary to the sixth face of the second optical-rotation optical member and located in proximity to the sixth face, and an eighth face of a planar shape substantially perpendicular to the optical axis, and
wherein the second optical-rotation optical member and the second correction optical member are integrally held.

44. An exposure apparatus for effecting exposure of a photosensitive substrate with a predetermined pattern, comprising:

the illumination optical apparatus as set forth in any one of claims 1 to 43, which illuminates the predetermined pattern or the photosensitive substrate.

45. The exposure apparatus according to claim 44, comprising:

a projection optical system which forms an image of the predetermined pattern on the photosensitive substrate;
a polarization state measuring unit which measures a polarization state of light at a pupil plane of the projection optical system or at a position substantially optically conjugate with the pupil plane; and
a control unit which controls the polarizing members, the phase member, or the optical rotation member, based on a measurement result by the polarization state measuring unit.

46. The exposure apparatus according to claim 45, wherein the polarization state measuring unit measures a polarization state of light having passed through the projection optical system.

47. The exposure apparatus according to claim 44, comprising:

a polarization state measuring unit which measures a polarization state of light at a position corresponding to the predetermined pattern or at a position corresponding to the photosensitive substrate; and

a control unit which controls the polarizing members, the phase member, or the optical rotation member, based on a measurement result by the polarization state measuring unit.

48. An exposure method for effecting exposure of a photosensitive substrate with a predetermined pattern, comprising:

an illumination step for illuminating the predetermined pattern or the photosensitive substrate, using the illumination optical apparatus as set forth in any one of claims 1 to 43.

49. The exposure method according to claim 48, comprising:

a polarization state measuring step for measuring a polarization state of light at a pupil plane of a projection optical system which forms an image of the predetermined pattern on the photosensitive substrate, or at a position substantially optically conjugate with the pupil plane; and
a control step for controlling the polarizing members, the phase member, or the optical rotation member, based on a measurement result in the polarization state measuring step.

50. The exposure method according to claim 49, wherein the polarization state measuring step comprises measuring a polarization state of light having passed through the projection optical system.

51. The exposure method according to claim 48, comprising:

a polarization state measuring step for measuring a polarization state of light at a position corresponding to the predetermined pattern or at a position corresponding to the photosensitive substrate; and
a control step for controlling the polarizing members, the phase member, or the optical rotation member, based on a measurement result in the polarization state measuring step.

52. A device manufacturing method comprising:

an exposure step for effecting exposure of a photosensitive substrate with a predetermined pattern, using the exposure apparatus as set forth in any one of claims 44 to 47; and
a development step for developing the photosensitive substrate exposed.

53. The device manufacturing method according to claim 52, comprising:

a polarization state measuring step for measuring a polarization state of light at a pupil plane of a projection optical system which forms an image of the predetermined pattern on the photosensitive substrate, or at a position substantially optically conjugate with the pupil plane; and
a control step for controlling the polarizing members, the phase member, or the optical rotation member, based on a measurement result in the polarization state measuring step.

54. The device manufacturing method according to claim 52, comprising:

a polarization state measuring step for measuring a polarization state of light at a position corresponding to the predetermined pattern or at a position corresponding to the photosensitive substrate; and
a control step for controlling the polarizing members, the phase member, or the optical rotation member, based on a measurement result in the polarization state measuring step.

55. An adjustment method for an illumination optical apparatus which illuminates a surface to be illuminated on the basis of light from a light source, comprising:

a polarization state measuring step for measuring a polarization state of light illuminating the surface to be illuminated; and
a polarizing member rotating step for rotating at least one of a first polarizing member disposed in an optical path of the illumination optical apparatus and a second polarizing member disposed in an optical path between the first polarizing member and the surface to be illuminated, around an optical axis of the illumination optical apparatus or around an axis substantially parallel to the optical axis, based on the polarization state measured.

56. The adjustment method according to claim 55, wherein the polarization state measuring step comprises measuring a polarization state of light at a pupil plane of a projection optical system which forms an image of a predetermined pattern on a photosensitive substrate, or at a position substantially optically conjugate with the pupil plane.

57. The adjustment method according to claim 55 or 56, wherein the polarization state measuring step comprises measuring the polarization state at a plurality of positions on the surface to be illuminated.

58. The adjustment method according to any one of claims 55 to 57, wherein the polarizing member rotating step comprises a rotation angle calculating step for calculating at least one of an angle of rotation of the first polarizing member and an angle of rotation of the second polarizing member, based on the polarization state measured.

59. A method for manufacturing an illumination optical apparatus which illuminates a surface to be illuminated on the basis of light from a light source, comprising:

a step for preparing a first polarizing member and a second polarizing member rotatable around an optical axis of the illumination optical apparatus or around an axis parallel to the optical axis; and
a step for rotationally adjusting at least one of the first polarizing member and the second polarizing member, according to the adjustment method as set forth in any one of claims 55 to 58.

EP 1 953 805 A1

# Fig.1

## Fig.2

# *Fig.3*

# Fig.4

# *Fig.5*

(a)                    (b)

# Fig.6

(a)

(b)

# Fig.7

(a)

(b)

## Fig.8

9B

41    42    43    44

AX

Y → Z

X

41a  42a  41b  44a  43b  44b
42b  43a

(a)

41

-X

AX

+X  41a    41b

(b)

# Fig.9

(a)

(b)

# Fig.10

# Fig.11

**Fig.12**

EP 1 953 805 A1

Fig.13

9    9E

21  22  24  23  41  42  46  45

AX

Y
  →Z
X

(a)

24b  24a  23b  23a  46a  46b  45a  45b

21  22  24  71  42  46  45

AX

(b)

71a  71b

41

## Fig.14

(a)

(b)

## Fig.15

# Fig.16

(a)

47C
47B
47A
47F
AX
47D
47E
47

Y ← Z
X ↓

(b)

47C 47F
47Ca
47B
47Ba
47Aa
AX
47Da
47Ea
47Cb
47Bb
47A
47Ab
47D
47Db
47Eb
47E
47

Y → Z
X ↓

(c)

48C
48B
48A
48F
AX
48D
48E
48

Y ← Z
X ↓

(d)

48C 48F
48Ca
48B
48Ba
48Aa
AX
48Da
48Ea
48Cb
48Bb
48A
48Ab
48D
48Db
48Eb
48E
48

Y → Z
X ↓

# *Fig.17*

(a)

(b)

(c)

(d)

# Fig.18

(a)

(b)

(c)

(d)

# Fig.19

(a)

27C
27B
27A
27D

27G(27F)
27G1
27G2
AX
27G3
27G4
27E

27

Y ← • Z

X

(b)

27C
27G

AX

27F
27B
27A
27D
27E

27

Y • → Z

X

(c)

28C
28B
28A
28D

28G(28F)
28G1
28G2
AX
28G3
28G4
28E

28

Y ← • Z

X

(d)

28C
28G

AX

28F
28B
28A
28D
28E

28

Y • → Z

X

# Fig.20

(a)

(b) A-A

(c) B-B

# *Fig.21*

37

37A3

37F

37A2

37A1

37A4

37A5

Y ← ● Z

AX

↓ X

(a)

37

AX

371A3

371A4  371A5

371A2

37F

Y ← ● X

↓ Z

37A1    37A2        37A4  37A5

37A3

(b)

# Fig.22

START

DEPOSIT METAL FILM ON WAFER ⟶ STEP301

APPLY PHOTORESIST ONTO THE METAL FILM ⟶ STEP302

TRANSFER IMAGE OF PATTERN ON RETICLE INTO EACH SHOT AREA ON WAFER, USING EXPOSURE APPARATUS OF EMBODIMENT ⟶ STEP303

PERFORM DEVELOPMENT OF PHOTORESIST ON WAFER ⟶ STEP304

PERFORM ETCHING ON WAFER, USING RESIST PATTERN AS MASK ⟶ STEP305

NEXT STEP

# Fig.23

```
        ┌──────────┐
        │  START   │
        └────┬─────┘
             │
             ▼
   ┌─────────────────────┐
   │ PATTERN FORMING STEP │──────── STEP401
   └─────────┬───────────┘
             │
             ▼
   ┌──────────────────────────┐
   │ COLOR FILTER FORMING STEP │──────── STEP402
   └─────────┬────────────────┘
             │
             ▼
   ┌──────────────────────┐
   │  CELL ASSEMBLY STEP   │──────── STEP403
   └─────────┬────────────┘
             │
             ▼
   ┌──────────────────────┐
   │ MODULE ASSEMBLY STEP  │──────── STEP404
   └─────────┬────────────┘
             │
             ▼
        ┌──────────┐
        │   END    │
        └──────────┘
```

## INTERNATIONAL SEARCH REPORT

| International application No. |
|---|
| PCT/JP2006/321607 |

| A. CLASSIFICATION OF SUBJECT MATTER |
|---|
| *H01L21/027*(2006.01)i, *G02B19/00*(2006.01)i, *G03F7/20*(2006.01)i |

According to International Patent Classification (IPC) or to both national classification and IPC

| B. FIELDS SEARCHED |
|---|
| Minimum documentation searched (classification system followed by classification symbols)<br>H01L21/027, G02B19/00, G03F7/20 |

Documentation searched other than minimum documentation to the extent that such documents are included in the fields searched
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>A | WO 2005/050718 A1 (Nikon Corp.),<br>02 June, 2005 (02.06.05),<br>Par. Nos. [0018], [0028] to [0037], [0051] to [0058]; Fig. 1<br>& US 2006/0158624 A1 & EP 1693885 A1 | 55,56,58,59<br>1-31,44-54,<br>57 |
| X<br>A | WO 2004/051717 A1 (Nikon Corp.),<br>17 June, 2004 (17.06.04),<br>Description; pages 42 to 46; Figs. 16 to 18<br>& US 2006/0055834 A1 | 55,56,58,59<br>1-31,44-54,<br>57 |
| A | JP 2005-302826 A (Nikon Corp.),<br>27 October, 2005 (27.10.05),<br>Par. Nos. [0031] to [0040]; Fig. 1<br>(Family: none) | 1-31,44-59 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>24 January, 2007 (24.01.07) | Date of mailing of the international search report<br>06 February, 2007 (06.02.07) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/321607 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2005-108925 A  (Nikon Corp.),<br>21 April, 2005 (21.04.05),<br>Par. Nos. [0037] to [0043]; Figs. 1, 4<br>(Family: none) | 1-31,44-59 |
| A | JP 2005-005521 A  (Nikon Corp.),<br>06 January, 2005 (06.01.05),<br>Claims; Figs. 1, 2<br>(Family: none) | 1-31,44-59 |

Form PCT/ISA/210 (continuation of second sheet) (April 2005)

## INTERNATIONAL SEARCH REPORT

| International application No. |
|---|
| PCT/JP2006/321607 |

---

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an
   extent that no meaningful international search can be carried out, specifically:

3. ☐ Claims Nos.:
   because they are dependent claims and are not drafted in accordance with the second and third sentences of Rule 6.4(a).

---

**Box No. III    Observations where unity of invention is lacking (Continuation of item 3 of first sheet)**

This International Searching Authority found multiple inventions in this international application, as follows:
"The special technical feature" of the inventions in independent claims
1 and 55 relates to first and second polarization members disposed so as
to be rotatable around the optical axis of a lighting optical system or an
axis almost parallel to the optical axis.  "The special technical feature"
of the inventions in independent claims 32 and 33 relates to a phase member
disposed so as to be rotatable around the optical axis of a lighting optical
system or an axis almost parallel to the optical axis.  "The special technical
feature" of the inventions in independent claims 36 and 37 relates to an
optical rotation member disposed so as to be rotatable around the optical
axis of a lighting optical system or    (continued to extra sheet)

1. ☐ As all required additional search fees were timely paid by the applicant, this international search report covers all searchable
   claims.

2. ☐ As all searchable claims could be searched without effort justifying an additional fee, this Authority did not invite payment of
   any additional fee.

3. ☐ As only some of the required additional search fees were timely paid by the applicant, this international search report covers
   only those claims for which fees were paid, specifically claims Nos.:

4. ☒ No required additional search fees were timely paid by the applicant.   Consequently, this international search report is
   restricted to the invention first mentioned in the claims; it is covered by claims Nos.: 1-31, 44-59

**Remark on Protest**
the

☐ The additional search fees were accompanied by the applicant's protest and, where applicable,
payment of a protest fee..

☐ The additional search fees were accompanied by the applicant's protest but the applicable protest
fee was not paid within the time limit specified in the invitation.

☐ No protest accompanied the payment of additional search fees.

Form PCT/ISA/210 (continuation of first sheet (2)) (April 2005)

**INTERNATIONAL SEARCH REPORT**

International application No.

PCT/JP2006/321607

Continuation of Box No.III of continuation of first sheet(2)

an axis almost parallel to the optical axis.
    These inventions are not considered to be so linked as to form a single general inventive concept, because there is no technical relationship among those inventions involving one or more of the same or corresponding special technical features.

Form PCT/ISA/210 (extra sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005041277 A
- JP 2005005521 A
- US 20060170901 A